# EUROPÄISCHE PATENTANMELDUNG

(11) **EP 2 355 172 A1**
(43) Veröffentlichungstag der Anmeldung: **10.08.2011**
(21) Anmeldenummer: 10152751.3
(22) Anmeldetag: 05.02.2010
(51) Int. Cl.: H01L 31/05

(54) **Verfahren zum Verbinden von Solarzellen**

(71) Anmelder: Scheuten S.à.r.l., 5916 PA Venlo (NL); Tourne Technologies Bv, 5709 RM Helmond (NL)
(72) Erfinder: Jacobus van den Oever, Petrus, NL-5622 GR Eindhoven (NL); Tourne, Joseph Anthonius Augustinus Maria, NL-5709 RM Helmond (NL)
(74) Vertreter: Jostarndt, Hans-Dieter

(57) **Zusammenfassung**

Die vorliegende Erfindung betrifft ein Verfahren zum Verbinden von Solarzellen, bei dem ein elektrisch leitendes Verbindungselement mit der Rückseite einer Solarzelle elektrisch leitend verbunden wird, wobei diese Solarzelle neben einer benachbarten Solarzelle platziert wird, sodass sich zumindest ein Teil des Verbindungselements nach der Platzierung der beiden Solarzellen und/oder der entsprechenden Verbindungselemente und/oder der beiden Verbünde aus jeweils einer Solarzelle und jeweils einem damit verbunden Verbindungselement bereits zumindest teilweise auf Höhe mindestens eines geeigneten Vorderkontakts der weiteren benachbarten Solarzelle befindet und somit durch die Berührung mindestens eines Teil des Verbindungselements,welches mit der Rückseite einer Solarzelle verbunden ist, und mindestens eines geeigneten Vorderkontakts einer weiteren benachbarten Solarzelle eine elektrische Verbindung zwischen den benachbarten Solarzellen hergestellt wird, wobei ferner die Gestaltung des Verbindungselements es ermöglicht, durch ein Verbindungselement jeweils immer nur zwei benachbarte Solarzellen miteinander zu verschalten.

## Beschreibung

Die vorliegende Erfindung betrifft ein Verfahren zum Verbinden von Solarzellen, bei dem ein elektrisch leitendes Verbindungselement mit der Rückseite einer Solarzelle elektrisch leitend verbunden wird, wobei diese Solarzelle neben einer benachbarten Solarzelle platziert wird, sodass sich zumindest ein Teil des Verbindungselements nach der Platzierung der beiden Solarzellen und/oder der entsprechenden Verbindungselemente und/oder der beiden Verbünde aus jeweils einer Solarzelle und jeweils einem damit verbunden Verbindungselement bereits zumindest teilweise auf Höhe mindestens eines geeigneten Vorderkontakts der weiteren benachbarten Solarzelle befindet und somit durch die Berührung mindestens eines Teil des Verbindungselements,welches mit der Rückseite einer Solarzelle verbunden ist, und mindestens eines geeigneten Vorderkontakts einer weiteren benachbarten Solarzelle eine elektrische Verbindung zwischen den benachbarten Solarzellen hergestellt wird, wobei ferner die Gestaltung des Verbindungselements es ermöglicht durch ein Verbindungselement jeweils immer nur zwei benachbarte Solarzellen miteinander zu verschalten.

Aus dem Stand der Technik sind Verfahren zum Verbinden von Solarzellen, insbesondere von Siliziumsolarzellen beziehungsweise von sogenannten H-Bar-Siliziumsolarzellen, bekannt, bei denen einzelne Solarzellen durch das Verlöten, insbesondere mit sogenannten Lötbändchen, zum Beispiel aus dünnen Metallstreifen, insbesondere zum Beispiel Kupfer- oder Aluminiumstreifen, gegebenenfalls verzinnt und einem entsprechenden Lot zu Solarzellketten beziehungsweise zu sogenannten Solarzell-Strings, verbunden werden. H-Bar-Silziumsolarzellen sind dabei wohl der am häufigsten produzierte und am einfachsten produzierbare Solarzellentyp. H-Bar-Solarzellen und insbesondere zum Beispiel H-Bar-Siliziumsolarzellen weisen auf der Vorderseite bevorzugt eine Vorderkontaktanordnung zumeist aus Silber auf, die ein Raster aus dünnen Silberlinien und zwei breitere damit verbundene auf Abstand angeordnete Silberstreifen als Sammelkontakte und Vorderkontakte aufweisen, welche wie ein H ohne Sprosse aussehen. Mehrere Solarzellketten beziehungsweise sogenannte Solarzell-Strings können dann anschließend als einzelne Reihen/Zeilen oder Spalten in beziehungsweise zu einem Solarmodul zusammengefügt werden.

Dabei müssen die einzelnen Solarzellen, insbesondere Siliziumsolarzellen beziehungsweise sogenannte H-Bar-Siliziumsolarzellen, zum Verlöten extensiv manipuliert und weitertransportiert werden. Die einzelnen Solarzellen müssen dabei insbesondere in einzelnen Schritten jeweils gegriffen und zum Verlöten zu einer Arbeitsstation gebracht werden. An dieser Arbeitsstation muss jede einzelne Solarzelle in Position gebracht werden, bevor Lötbändchen auf die Vorderkontakte aufgebracht werden. Innerhalb einer Solarzellkette beziehungsweise eines sogenannten Solarzell-Strings kann eine Solarzelle dabei mit der Rückseite auf die Lötbändchen gelegt werden, welche auf den Vorderkontakten der vorherigen Solarzelle in der Kette verlötet wurden. Jede Solarzelle mit aufgebrachten Lötbändchen wird zu einer weiteren Arbeitsstation transportiert, wo die Lötbändchen mit den Vorderkontakten und/oder der Rückseite der jeweiligen Zelle verlötet werden. Die über die Lötbändchen verbundenen Solarzellen bilden dabei Solarzellketten beziehungsweise sogenannten Solarzell-Strings. Die gesamte Solarzellkette mit allen dazugehörigen Solarzellen, die lediglich über die Lötbändchen verbunden sind, wird nach dem Verlöten jeweils schrittweise weiterbewegt, um die Arbeitsstationen für weitere Solarzellen zu räumen, die der Kette beziehungsweise dem String hinzugefügt werden oder den Anfang einer neuen Kette beziehungsweise eines neuen Strings bilden.

Bei all diesen Arbeitsschritten können die Solarzellen und/oder die Solarzellketten beziehungsweise die Verbindungen zwischen einzelnen Solarzellen leicht beschädigt werden, da Solarzellen und insbesondere Siliziumsolarzellen sehr dünne, spröde und empfindliche Siliziumwafer umfassen und die Verbindungen der einzelnen Solarzellen über die dünnen Lötbändchen nur eine äußerst geringe mechanische Stabilität ausweisen.

Darüber hinaus müssen die Solarzellketten beziehungsweise die sogenannten Solarzell-Strings, die mehrere miteinander lediglich über die Lötbändchen verbundene Solarzellen umfassen, auch nach ihrer eigentlichen Herstellung zur Bildung von Solarmodulen extensiv manipuliert und transportiert werden. Insbesondere können die Solarzellketten dabei mit allen dazugehörigen Solarzellen jeweils gegriffen und gegebenenfalls ein oder mehrmals gedreht und/oder gewendet und/oder weitertransportiert werden.

Auch bei diesen weiteren Arbeitsschritten können die Solarzellen und/oder die Solarzellkette beziehungsweise die Verbindungen zwischen einzelnen Solarzellen leicht beschädigt werden, da Solarzellen und insbesondere Siliziumsolarzellen sehr dünne, spröde und empfindliche Siliziumwafer umfassen und die Verbindungen der einzelnen Solarzellen über die dünnen Lötbändchen nur eine äußerst geringe mechanische Stabilität ausweisen.

Bei einer Beschädigung der Solarzellen und/oder der Solarzellketten beziehungsweise einer der Verbindungen zwischen den einzelnen Solarzellen kann bei der Produktion von Solarmodulen erheblicher Ausschuss anfallen. Zudem kann auch der Produktionsfluss gegebenenfalls erheblich gestört werden, da die Produktion unter Umständen gestoppt werden muss, um beschädigte Elemente aus der Produktionslinie zu entfernen, bevor die Produktion weiterlaufen kann.

Deshalb werden im Stand der Technik auch Verfahren beschrieben, bei denen keine normalen H-Bar-Siliziumsolarzellen, sondern spezielle PUM- (Pin-up module), MWT-(Metal wrap through) oder EWT-Solarzellen (Emitter wrap through) zur Herstellung von Solarmodulen verwendet werden. Diese Solarzellen beziehungsweise Solarzelltypen weisen sämtliche Kontakte auf der Rückseite auf und erfordern keine Kontaktierung der Vorderseite. Dadurch können einzelne Solarzellen über eine rückseitige Modulverschaltung zu einem Modul miteinander verbunden und zum Beispiel reihenweise in Serie geschaltet werden. Die Modulverschaltung weist dabei vorgesehene Plätze für die einzelnen Solarzellen eines geplanten Solarmoduls auf, sodass diese Solarzellen durch eine geeignete Verschaltung miteinander verbunden und zum Beispiel reihenweise in Serie geschaltet werden können.

Einzelne Solarzellen werden dazu mit ihren Kontakten lediglich am richtigen Platz und gegebenenfalls mit der richtigen Ausrichtung auf die Modulverschaltung gelegt und eventuell noch mit ihr verbunden, zum Beispiel durch elektrisch leitenden Kleber, um miteinander elektrisch verbunden und zum Beispiel reihenweise oder in Serie geschaltet zu werden.

Dabei muss die vorgesehene Modulverschaltung jedoch jeweils an die Position der Kontakte auf der Rückseite der Solarzellen in Abhängigkeit des verwendeten Solarzelltyps angepasst werden.

Darüber hinaus muss die vorgesehene Modulverschaltung zudem umständlich an die Form und Größe des jeweils gewünschten Solarmoduls angepasst werden. Unterschiedliche Modulgrößen und Modulformen benötigen dabei unterschiedlich gestaltete Verschaltungen. Die Anzahl der vorgesehenen Plätze für Solarzellen und deren Anordnung muss dabei in Abhängigkeit der Größe und der Form des jeweils gewünschten Moduls gegebenenfalls angepasst werden.

Bei der Fertigung von Modulen in verschiedenen Formen und Größen kann relativ schnell ein großer Anpassungsaufwand entstehen.

Des Weiteren lassen sich keine günstigen und bequem herstellbaren H-Bar-Siliziumsolarzellen mit mindestens einem Vorderkontakt verwenden. Dies schränkt die Wahl der Zulieferer erheblich ein.

Angesichts des Stands der Technik besteht daher der Bedarf an einem Verfahren zum Verbinden von Solarzellen zur Herstellung eines Solarmoduls, bei dem das Risiko einer Beschädigung der Solarzellen oder der Verbindungen der einzelnen Solarzellen durch eine Vielzahl von Arbeitsschritten, insbesondere zum Beispiel von Manipulations- und Transportschritten zum Verbinden der einzelnen Solarzellen, möglichst reduziert wird und wobei gleichzeitig jedoch eine große Flexibilität bezüglich des verwendeten Solarzellentyps und/oder der Form und/oder Größe des hergestellten Solarmoduls gewährleistet bleibt.

Es ist daher die Aufgabe der vorliegenden Erfindung, ein solches Verfahren zur Verfügung zu stellen.

Dies wird durch ein Verfahren zum Verbinden von Solarzellen mit den Merkmalen des Anspruchs 1 erreicht.

Weitere vorteilhafte Ausführungsformen des erfindungsgemäßen Verfahrens ergeben sich aus der Beschreibung, den Unteransprüchen und den Zeichnungen.

Die vorliegende Erfindung betrifft dabei ein Verfahren zum Verbinden von Solarzellen, bei dem ein elektrisch leitendes Verbindungselement mit der Rückseite einer Solarzelle elektrisch leitend verbunden wird, wobei diese Solarzelle neben einer benachbarten Solarzelle platziert wird, sodass sich zumindest ein Teil des Verbindungselements nach der Platzierung der beiden Solarzellen und/oder der entsprechenden Verbindungselemente und/oder der beiden Verbünde aus jeweils einer Solarzelle und jeweils einem damit verbunden Verbindungselement bereits zumindest teilweise auf Höhe mindestens eines geeigneten Vorderkontakts der weiteren benachbarten Solarzelle befindet und somit durch die Berührung mindestens eines Teil des Verbindungselements,welches mit der Rückseite einer Solarzelle verbunden ist, und mindestens eines geeigneten Vorderkontakts einer weiteren benachbarten Solarzelle eine elektrische Verbindung zwischen den benachbarten Solarzellen hergestellt wird, wobei ferner die Gestaltung des Verbindungselements es ermöglicht, durch ein Verbindungselement jeweils immer nur zwei benachbarte Solarzellen miteinander zu verschalten.

Durch das erfindungsgemäße Verfahren können die Manipulations- und Transportschritte zum Verbinden der einzelnen Solarzellen und somit das Risiko einer Beschädigung der Solarzellen oder der Verbindungen der einzelnen Solarzellen erheblich reduziert werden, da die Solarzellen zum Verbinden mit den Verbindungselementen nur noch gegebenenfalls mit der richtigen Ausrichtung nebeneinander platziert werden müssen, um erfindungsgemäß zum Beispiel eine Serienverschaltung von jeweils zwei benachbarten Solarzellen durch ein Verbindungselement sicherzustellen.

Darüber hinaus werden die Solarzellen und insbesondere Siliziumsolarzellen, die sehr dünne, spröde und empfindliche Siliziumwafer umfassen, durch die mit der Rückseite der Solarzellen beziehungsweise der Siliziumwafer verbundenen Verbindungselemente mechanisch verstärkt beziehungsweise unterstützt. Dadurch kann das Risiko einer Beschädigung der Solarzellen und insbesondere von Siliziumsolarzellen, die sehr dünne, spröde und empfindliche Siliziumwafer umfassen, grundsätzlich weiter reduziert werden.

Gleichzeitig ermöglicht das erfindungsgemäße Verfahren zudem eine hohe Flexibilität bezüglich der Form und der Größe der gefertigten Solarmodule, da die Verbindungselemente lediglich jeweils immer nur zwei benachbarte Solarzellen miteinander verbinden. Dadurch ist es möglich, Solarmodule flexibel in verschiedenen Formen und Größen mit den gleichen Verbindungselementen herzustellen. In der Tat wird jede Solarzelle erfindungsgemäß durch ein Verbindungselement jeweils immer nur mit einer benachbarten Solarzelle verschaltet, sodass die Form und die Größe der hergestellten Solarmodule einfach durch die Anzahl und Anordnung der verwendeten Solarzellen verändert werden, wobei die Verschaltung jeder Solarzelle mit einer jeweils benachbarten weiteren Solarzelle erfindungsgemäß durch Verbindungselemente ermöglicht wird.

Solarzellen im Sinne der vorliegenden Erfindung können insbesondere zum Beispiel Solarzellen auf Silizium-Basis umfassen bevorzugterweise Siliziumsolarzellen, zum Beispiel monokristalline Siliziumsolarzellen, polykristalline Siliziumsolarzellen, amorphe Siliziumsolarzellen oder Tandem Siliziumsolarzellen, die eine Kombination der vorgenannten Siliziumsolarzelltypen darstellen können.

Dabei können erfindungsgemäß insbesondere jegliche Solarzellen verwendet werden, die mindestens einen Vorderkontakt aufweisen. Besonders bevorzugt können zum Beispiel die bekannten H-Bar-Solarzellen, die mindestens einen Vorderkontakt aufweisen, verwendet werden.

Ein elektrisch leitendes Verbindungselement im Sinne der Erfindung kann dabei zum Beispiel insbesondere jedes elektrische leitende Element sein, welches dazu verwendet werden kann, um eine elektrische Verbindung zwischen zwei Solarzellen innerhalb eines Solarmoduls sicherzustellen.

Elektrisch leitend im Sinne der vorliegenden Erfindung kann dabei insbesondere zum Beispiel bedeuten, dass elektrischer Strom ausreichend geleitet wird, um eine elektrische Verbindung zwischen zwei Solarzellen innerhalb eines Solarmoduls sicherzustellen. Elektrisch leitend im Sinne der vorliegenden Erfindung kann dabei zum Beispiel bedeuten, dass der elektrische Widerstand oder die elektrische Leitfähigkeit insbesondere zum Beispiel zwischen 0,005 Ohm und 20 Ohm, bevorzugt zwischen 0,01 Ohm und 10 Ohm, bevorzugt zwischen 0,05 Ohm und 5 Ohm, weiter bevorzugt zwischen 0,075 Ohm und 2 Ohm, weiter bevorzugt zwischen 0,09 Ohm und 1 Ohm, weiter bevorzugt zwischen 0,1 Ohm und 0,5 Ohm, respektive zum Beispiel zwischen 1 ×10⁶ Siemens pro Meter und 70 ×10⁶ Siemens pro Meter, bevorzugt zwischen 3 ×10⁶ Siemens pro Meter und 65 ×10⁶ Siemens pro Meter, weiter bevorzugt zwischen 5 ×10⁶ Siemens pro Meter und 60 ×10⁶ Siemens pro Meter, weiter bevorzugt zwischen 10×10⁶ Siemens pro Meter und 30×10⁶ Siemens pro Meter betragen kann.

Die Rückseite einer Solarzelle im Sinne der vorliegenden Erfindung kann dabei zum Beispiel insbesondere die Seite der Solarzelle beziehungsweise gegebenenfalls des Siliziumwafers darstellen, die nicht zur Aufnahme von Sonnenlicht bestimmt ist, beziehungsweise von der Sonne abgewendet in einem Solarmodul angeordnet wird.

Verbinden oder verbunden im Sinne der vorliegenden Erfindung kann dabei insbesondere zum Beispiel bedeuten, dass eine Verbindung beziehungsweise Kopplung hergestellt wird, welche die verbundenen Teile aneinander befestigt. Bevorzugterweise kann die Verbindung beziehungsweise Kopplung beim Verbinden zum Beispiel durch Löten oder Kleben erfolgen.

Kleben oder Verkleben beziehungsweise geklebt oder verklebt im Sinne der vorliegenden Erfindung kann dabei zum Beispiel insbesondere durch einen geeigneten Stoff beziehungsweise ein geeignetes Stoffgemisch durch Adhäsion verbunden bedeuten. Dabei kann die Verbindung durch Adhäsion bevorzugterweise durch das Aushärten des zum Kleben oder Verkleben verwendeten Stoffes beziehungsweise Stoffgemischs erfolgen, wobei das Aushärten bevorzugt ohne Wärmeeinwirkung beziehungsweise bei Umgebungstemperatur stattfindet.

Bevorzugterweise kann Kleben oder Verkleben beziehungsweise geklebt oder verklebt erfindungsgemäß elektrisch leitend kleben oder verkleben beziehungsweise elektrisch leitend geklebt oder verklebt bedeuten. Der zum Kleben beziehungsweise zum Verkleben verwendete Stoff beziehungsweise das entsprechende Stoffgemisch kann bevorzugterweise nicht nur erlauben, eine Verbindung durch Adhäsion herzustellen, sondern zudem gegebenenfalls elektrisch leitend sein. Dabei kann bevorzugterweise durch das Kleben eine elektrische Verbindung zwischen dem verklebten Teil der Rückseite der Solarzelle und dem Verbindungselement hergestellt werden. Zum Kleben beziehungsweise zum Verkleben im Sinne der vorliegenden Erfindung kann dabei mindestens ein beliebiges elektrisch leitendes Adhäsiv beziehungsweise mindestens ein beliebiger elektrisch leitender Kleber, wie zum Beispiel Leitsilber, insbesondere Silberlack oder Silberpaste oder Mischungen davon sowie Mischungen eines Adhäsivs/Klebers, zum Beispiel auf Epoxi- und/ oder Acrylat-Basis mit elektrisch leitenden Teilchen, zum Beispiel Gold-, Silber-, Kupfer-, Nickel-, Nickel-Silber- oder Kohlenstoff-Teilchen (zum Beispiel insbesondere auch Graphit-Teilchen und/oder Fullerene und/oder Nanotubes) oder Mischungen dieser Adhäsive/Kleber und/oder der entsprechenden elektrisch leitenden Teilchen, verwendet werden. Ein elektrisch leitendes Adhäsiv kann dabei insbesondere zum Beispiel jeder Stoff oder jedes Stoffgemisch darstellen, welches zum Herstellen einer elektrisch leitenden Verbindung zwischen der Rückseite einer Solarzelle und dem Verbindungselement durch Adhäsion und insbesondere zum Beispiel durch das Aushärten des Stoffes oder Stoffgemischs geeignet sein kann, wobei das Aushärten bevorzugt ohne Wärmeeinwirkung beziehungsweise bei Umgebungstemperatur stattfindet. Dabei kann durch das elektrisch leitende Verkleben der Rückseite der Solarzelle und des Verbindungselements eine elektrische Verbindung zwischen der Rückseite der Solarzelle und dem Verbindungselement ohne Löten beziehungsweise bei Raumtemperatur hergestellt werden. Dies ermöglicht es, das Risiko von Beschädigungen durch Verspannungen in den Solarzellen beziehungsweise in den Siliziumwafern zu reduzieren, da solche Verspannungen hauptsächlich durch das Erwärmen beim Löten entstehen können.

Alternativ kann auch mindestens ein niedrig schmelzendes Lot, das bevorzugterweise zum Beispiel eine Schmelztemperatur von unter 200 ° C, bevorzugt unter 185°C, weiter bevorzugt unter 175 °C, weiter bevorzugt unter 150°C, weiter bevorzugt unter 140°C , weiter bevorzugt unter 135°C, , weiter bevorzugt unter 130°C, weiter bevorzugt unter 125°C, weiter bevorzugt unter 120°C, weiter bevorzugt unter 110°C, jedoch bevorzugt zum Beispiel von über 90 °C, weiter bevorzugt zum Beispiel von über 95 °C, weiter bevorzugt zum Beispiel von über 100 °C aufweist, zum verbinden der Solarzelle mit dem Verbindungselement verwendet werden. Durch niedrig schmelzende Lote kann ebenfalls eine bevorzugt elektrisch leitende Verbindung hergestellt werden. Zudem kann das Risiko von Beschädigungen durch Verspannungen in den Solarzellen beziehungsweise in den Siliziumwafern durch die Verwendung von niedrig schmelzenden Loten reduziert werden, da solche Verspannungen, die hauptsächlich durch das Erwärmen beim Löten entstehen können, durch die verwendeten niedrigen Temperaturen möglichst vermieden werden können. Dabei kann die Schmelztemperatur bevorzugt zum Beispiel so gewählt werden, dass die Verbindung durch das niedrig schmelzende Lot beziehungsweise die Lötstellen/Lötpunkte insbesondere zum Beispiel im Betrieb beziehungsweise bei Betriebstemperatur ausreichend widerstandsfähig sind.

Die Rückseite der Solarzelle kann dabei ganz oder nur teilweise mit dem Verbindungselement und insbesondere mit dem Basisteil des Verbindungselements verbunden beziehungsweise verklebt werden. Insbesondere kann die Rückseite der Solarzelle zum Beispiel vollflächig, teilflächig oder punktuell mit dem Verbindungselement und insbesondere mit dem Basisteil des Verbindungselements verbunden beziehungsweise verklebt werden. Vollflächig verbunden beziehungsweise verklebt kann dabei bedeuten, dass die gesamte Fläche der Rückseite der Solarzelle mit dem Verbindungselement und insbesondere mit dem Basisteil des Verbindungselements verbunden beziehungsweise verklebt wird, wobei bevorzugt eine Verbindungsfläche entstehen kann. Sofern die Solarzelle teilflächig mit dem Verbindungselement und insbesondere mit dem Basisteil des Verbindungselements verbunden beziehungsweise verklebt ist, kann lediglich mindestens ein Teil oder bevorzugt mehrere Teile der Fläche der Rückseite der Solarzelle flächig mit dem Verbindungselement und insbesondere mit dem Basisteil des Verbindungselements verbunden beziehungsweise verklebt werden, sodass zum Beispiel mindestens eine und bevorzugt jedoch mehrere Verbindungsfläche(n) entstehen kann/können. Sofern mehrere Teile der Rückseite der Solarzelle jeweils flächig mit dem Verbindungselement und insbesondere mit dem Basisteil des Verbindungselements verbunden beziehungsweise verklebt werden, kann jeder Teil der Rückseite der Solarzelle, der jeweils flächig mit dem Verbindungselement und insbesondere mit dem Basisteil des Verbindungselements verbunden beziehungsweise verklebt wird, gegebenenfalls von mindestens einem anderen Teil der Rückseite der Solarzelle, der jeweils flächig mit dem Verbindungselement verbunden beziehungsweise verklebt wird, durch mindestens einen Teil der Rückseite der Solarzelle, der nicht mit dem Verbindungselement verbunden beziehungsweise verklebt wird, getrennt sein. Mehrere Teile der Rückseite der Solarzelle, welche mit einem Verbindungselement verbunden beziehungsweise verklebt werden, können demnach auf Abstand zueinander angeordnet sein. Dabei können zum Beispiel insbesondere mindestens 1%, bevorzugt mindestens 2 %, weiter bevorzugt mindestens 3 % , weiter bevorzugt mindestens 4 %, weiter bevorzugt mindestens 5 %, weiter bevorzugt mindestens 10%, weiter bevorzugt mindestens 15 %, weiter bevorzugt mindestens 20 %, weiter bevorzugt mindestens 25 %, weiter bevorzugt mindestens 30 %, weiter bevorzugt mindestens 35 %, weiter bevorzugt mindestens 40 %, weiter bevorzugt mindestens 45 %, noch weiter bevorzugt mindestens 50 %, noch weiter bevorzugt mindestens 55 %, noch weiter bevorzugt mindestens 60 %, noch weiter bevorzugt mindestens 65 %, noch weiter bevorzugt mindestens 70 %, noch weiter bevorzugt mindestens 75 %, noch weiter bevorzugt mindestens 80 %, noch weiter bevorzugt mindestens 85 %, noch weiter bevorzugt mindestens 90 %, noch weiter bevorzugt mindestens 92,5 %, noch weiter bevorzugt mindestens 95 %, noch weiter bevorzugt mindestens 97,5 %, noch weiter bevorzugt mindestens 99 %, noch weiter bevorzugt mindestens 100 % der Fläche der Rückseite der Solarzelle mit dem Verbindungselement und insbesondere mit dem Basisteil des Verbindungselements verbunden beziehungsweise verklebt werden. Des Weiteren können zum Beispiel insbesondere maximal 1 %, bevorzugt maximal 2 %, weiter bevorzugt maximal 3 % , weiter bevorzugt maximal 4 %, weiter bevorzugt maximal 5 %, weiter bevorzugt maximal 10%, weiter bevorzugt maximal 15 %, weiter bevorzugt maximal 20 %, weiter bevorzugt maximal 25 %, weiter bevorzugt maximal 30 %, weiter bevorzugt maximal 35 %, weiter bevorzugt maximal 40 %, weiter bevorzugt maximal 45 %, noch weiter bevorzugt maximal 50 %, noch weiter bevorzugt maximal 55 %, noch weiter bevorzugt maximal 60 %, noch weiter bevorzugt maximal 65 %, noch weiter bevorzugt maximal 70 %, noch weiter bevorzugt maximal 75 %, noch weiter bevorzugt maximal 80 %, noch weiter bevorzugt maximal 85 %, noch weiter bevorzugt maximal 90 %, noch weiter bevorzugt maximal 92,5 %, noch weiter bevorzugt maximal 95 %, noch weiter bevorzugt maximal 97,5 %, noch weiter bevorzugt maximal 99 %, noch weiter bevorzugt maximal 100 % der Fläche der Rückseite der Solarzelle mit dem Verbindungselement und insbesondere mit dem Basisteil des Verbindungselements verbunden beziehungsweise verklebt werden. Zudem können dabei zum Beispiel zwischen 100 und 1, bevorzugt zwischen 50 und 2, weiter bevorzugt zwischen 25 und 3, weiter bevorzugt zwischen 15 und 4, weiter bevorzugt zwischen 10 und 5 Teile der Fläche der Rückseite der Solarzelle mit dem Verbindungselement und insbesondere mit dem Basisteil des Verbindungselements verbunden beziehungsweise verklebt werden. Je größer die Fläche des Teils und/oder der Teile der Rückseite der Solarzelle, welche mit dem Verbindungselement und insbesondere mit dem Basisteil des Verbindungselements verbunden beziehungsweise verklebt wird/werden, und/oder je mehr Teile der Fläche der Rückseite der Solarzelle mit dem Verbindungselement verbunden beziehungsweise verklebt sind, desto besser kann gegebenenfalls elektrischer Strom über das Verbindungselement abgeführt werden. Durch das Verbinden beziehungsweise Verkleben eines ausreichend großen Teils der Fläche der Rückseite der Solarzelle und/oder einer ausreichend großen Anzahl von Teilen der Fläche der Rückseite der Solarzelle mit einem Verbindungselement und insbesondere mit dem Basisteil des Verbindungselements kann dabei gegebenenfalls sichergestellt werden, dass elektrischer Strom ausreichend abgeführt werden kann. Ausreichend abgeführt kann elektrischer Strom im Sinne der vorliegenden Erfindung zum Beispiel dann werden, wenn Veränderungen des elektrischen Füllfaktors des Moduls möglichst gering ausfallen beziehungsweise wenn der elektrische Widerstand ausreichend gering ist, um unzulässig große Veränderungen des elektrischen Füllfaktors des Moduls möglichst zu verhindern. Dadurch, dass lediglich ein oder mehrere Teil(e) der Rückseite der Solarzelle jeweils flächig mit dem Verbindungselement und insbesondere mit dem Basisteil des Verbindungselements verbunden beziehungsweise verklebt wird/werden, kann im Vergleich zum Verbinden beziehungsweise Verkleben der gesamten Rückseite der Solarzelle mit dem Verbindungselement gegebenenfalls Lot oder Adhäsiv insbesondere teures elektrisch leitendes Adhäsiv eingespart werden, wobei jedoch zudem noch sichergestellt werden kann, dass elektrischer Strom ausreichend abgeführt werden kann.

Schließlich kann die Rückseite der Solarzelle bevorzugterweise auch nur punktuell mit dem Verbindungselement und insbesondere mit dem Basisteil des Verbindungselements verbunden beziehungsweise verklebt werden, wobei mindestens ein, aber bevorzugt mehrere, Verbindungpunkt(e) beziehungsweise zum Beispiel Lötpunkt(e) oder Klebepunkt(e) auf der Fläche der Rückseite der Solarzelle oder/oder der Fläche des Verbindungselements, insbesondere des Basisteils des Verbindungselements, auf Abstand zueinander angeordnet werden. Der Abstand zwischen den Verbindungspunkten beziehungsweise den Lötpunkten oder den Klebepunkten dann dabei bevorzugt zum Beispiel regelmäßig beziehungsweise gleich sein, sodass elektrischer Strom über die gesetzten bevorzugt elektrisch leitenden Verbindungspunkte beziehungsweise Lötpunkte oder Klebepunkte ausreichend abgeführt werden kann. Bevorzugterweise können die elektrisch leitenden Verbindungspunkte beziehungsweise Lötpunkte oder Klebepunkte so gesetzt werden, dass die maximale Distanz zwischen zwei Verbindungspunkten beziehungsweise Lötpunkten oder Klebepunkten zum Beispiel zwischen 70 mm und 0,5 mm, weiter bevorzugt zwischen 50 mm und 1 mm, weiter bevorzugt zwischen 25 mm und 1,5 mm, bevorzugt zwischen 15 mm und 1,7 mm, weiter bevorzugt zwischen 10 mm und 2 mm, betragen kann. Zudem kann die Anzahl der Verbindungspunkte beziehungsweise Lötpunkte oder Klebepunkte zum Beispiel zwischen 1000 und 1, bevorzugt zwischen 500 und 2, bevorzugt zwischen 100 und 3, weiter bevorzugt zwischen 50 und 4, weiter bevorzugt zwischen 20 und 5 betragen. Dabei kann es durch leitende Verbindungspunkte beziehungsweise Lötpunkte oder Klebepunkte, welche zum Beispiel in ausreichender Anzahl und/oder mit dem richtigen Abstand zueinander bevorzugt zum Beispiel regelmäßig über die Oberfläche verteilt und/oder nah aneinander vorgesehen sind, ermöglicht werden, dass elektrischer Strom ausreichend beziehungsweise ohne größere Verluste abgeführt werden kann. Dabei kann die Fläche, bevorzugt zum Beispiel in gleich große und/oder ungefähr gleich große Flächenteile, bevorzugt zum Beispiel Quadrate aufgeteilt werden, um Verbindungspunkte beziehungsweise Lötpunkte oder Klebepunkte jeweils im Zentrum dieser Flächenteile beziehungsweise dieser Quadrate zu setzen und somit einen regelmäßigen Abstand zwischen den Verbindungspunkte beziehungsweise Lötpunkte oder Klebepunkten zu erhalten. Sofern die Solarzelle punktuell mit dem Verbindungselement und insbesondere mit dem Basisteil des Verbindungselements verbunden beziehungsweise verklebt wird, kann/können ebenfalls lediglich mindestens ein Teil oder bevorzugt mehrere Teile der Fläche der Rückseite der Solarzelle jeweils punktuell mit dem Verbindungselement und insbesondere mit dem Basisteil des Verbindungselements verbunden beziehungsweise verklebt werden. Dabei kann jeder Teil der Rückseite der Solarzelle, der jeweils punktuell mit dem Verbindungselement und insbesondere mit dem Basisteil des Verbindungselements verbunden beziehungsweise verklebt wird, gegebenenfalls von mindestens einem anderen Teil der Rückseite der Solarzelle, der jeweils punktuell mit dem Verbindungselement verbunden beziehungsweise verklebt wird, durch mindestens einen Teil der Rückseite der Solarzelle, der nicht mit dem Verbindungselement und insbesondere mit dem Basisteil des Verbindungselements verbunden beziehungsweise verklebt wird, getrennt sein. Mehrere Teile der Rückseite der Solarzelle, welche mit einem Verbindungselement und insbesondere mit dem Basisteil des Verbindungselements verbunden beziehungsweise verklebt werden, können demnach auf Abstand zueinander angeordnet sein. Dadurch, dass die Rückseite der Solarzelle nur punktuell an einem oder mehreren Punkten mit dem Verbindungselement und insbesondere mit dem Basisteil des Verbindungselements verbunden beziehungsweise verklebt wird, kann im Vergleich zum Verbinden beziehungsweise zum Verkleben der gesamten Rückseite beziehungsweise von einem oder mehreren Teil(en) der Rückseite der Solarzelle mit dem Verbindungselement gegebenenfalls weiter Lot oder Adhäsiv insbesondere teures elektrisch leitendes Adhäsiv eingespart werden, wobei jedoch zudem noch sichergestellt werden kann, dass elektrischer Strom ausreichend abgeführt werden kann.

Die Gestaltung des Verbindungselements im Sinne der vorliegenden Erfindung kann dabei insbesondere zum Beispiel die Form des Verbindungselementes darstellen. Dabei kann die Gestaltung beziehungsweise die Form des Verbindungselements erfindungsgemäß zum Beispiel insbesondere in Abhängigkeit der verwendeten Solarzelle und insbesondere der Form der Solarzelle, des Solarzelltyps, der vorgesehenen Kontakte und/oder der Größe der Solarzelle gewählt beziehungsweise verändert werden. Die Gestaltung beziehungsweise die Form des Verbindungselements kann dabei erfindungsgemäß bevorzugterweise zum Beispiel in Abhängigkeit der verwendeten Solarzelle und insbesondere der Form der Solarzelle, des Solarzelltyps, der vorgesehenen Kontakte und/oder der Größe der Solarzelle ermöglichen, dass sich ein Teil des Verbindungselementes und insbesondere des Verbindungsteils des Verbindungselements nach der Platzierung einer Solarzelle, deren Rückseite erfindungsgemäß mit einem Verbindungselement und insbesondere mit dem Basisteil des Verbindungselements verbunden beziehungsweise verklebt wurde, neben einer weiteren benachbarten Solarzelle bereits auf Höhe eines geeigneten Vorderkontakts der weiteren benachbarten Solarzelle befindet. Die Gestaltung des Verbindungselements kann dabei zum Beispiel durch ein Ausschneiden/Zurechtschneiden beziehungsweise Ausstanzen der geeigneten Form sowie gegebenenfalls durch eine Verformung durch einen oder mehrere Falt-, Press-, insbesondere Formpress- oder Verbiegeschritt(e), erreicht werden. Insbesondere kann das Material zum Herstellen des Verbindungselements vor und/oder nach dem Ausstanzen beziehungsweise Ausschneiden, optional zum Beispiel unter Wärmeeinwirkung, in eine Form gepresst werden, um das Verbindungselement in Form zu bringen und die gegebenenfalls gewünschte Gestaltung zu erhalten. Die Gestaltung des Verbindungselements kann dabei zum Beispiel plan oder nicht plan sein. Eine nicht plane Gestaltung der Verbindungselemente kann es zum Beispiel erlauben, wenn Solarzellen mit einem oder mehreren Vorderkontakt(en), insbesondere zum Beispiel normale H-Bar-Siliziumsolarzellen, zum Herstellen von Solarmodulen verwendet werden, die Rückseite einer Solarzelle mit einem oder mehreren Vorderkontakt(en), insbesondere zum Beispiel einer H-Bar-Siliziumsolarzelle, welche mit dem Basisteil eines Verbindungselements verbunden beziehungsweise verklebt sein kann, bevorzugt mit mindestens einem Vorderkontakt einer weiteren benachbarten Solarzelle mit einem oder mehreren Vorderkontakt(en), insbesondere zum Beispiel einer benachbarten H-Bar-Siliziumsolarzelle, besonders bequem zu verbinden, um eine Verschaltung der Solarzellen durch das Verdingungselement zu erreichen. In der Tat ist eine nicht plane Gestaltung der Verbindungselemente insbesondere zum Beispiel bei der Verwendung von Solarzellen mit einem oder mehreren Vorderkontakt(en), insbesondere zum Beispiel von normalen H-Bar-Siliziumsolarzellen, bevorzugt, da bei der Verwendung dieses Solarzellentyps die Rückseite einer Solarzelle mit einem oder mehreren Vorderkontakt(en), insbesondere zum Beispiel einer H-Bar-Siliziumsolarzelle, und mindestens ein Vorderkontakt einer weiteren benachbarten Solarzelle mit einem oder mehreren Vorderkontakt(en), insbesondere zum Beispiel einer benachbarten H-Bar-Siliziumsolarzelle, gegebenenfalls nicht in einer Ebene liegen. Um den Höhenunterschied zwischen der Ebene der Rückseite einer Solarzelle mit einem oder mehreren Vorderkontakt(en), insbesondere zum Beispiel einer H-Bar-Siliziumsolarzelle, und der Ebene eines Vorderkontakts einer benachbarten Solarzelle mit einem oder mehreren Vorderkontakt(en), insbesondere zum Beispiel einer benachbarten H-Bar-Siliziumsolarzelle, zu überbrücken und somit eine bequeme Verschaltung der Rückseite einer Solarzelle mit einem oder mehreren Vorderkontakt(en), insbesondere zum Beispiel einer H-Bar-Siliziumsolarzelle, und mindestens eines Vorderkontakts einer weiteren benachbarten Solarzelle mit einem oder mehreren Vorderkontakt(en), insbesondere zum Beispiel einer benachbarten H-Bar-Siliziumsolarzelle, durch das Verbindungselement zu ermöglichen, kann demnach eine nicht plane Gestaltung des Verbindungselements bevorzugt werden. Alternativ dazu kann das Verbindungselement beziehungsweise das Verbindungsteil des Verbindungselements insbesondere bei einer planen Gestaltung des Verbindungselements zum elektrisch leitenden Verbinden mit einem geeigneten Vorderkontakt einer benachbarten Solarzelle auch leicht gebogen/verbogen werden, um den Höhenunterschied zwischen der Rückseite der Solarzelle, welche mit dem Verbindungselement und insbesondere dem Basisteil des Verbindungselements verbunden beziehungsweise verklebt ist, und dem Vorderkontakt einer benachbarten Solarzelle, welcher nicht in der gleichen Ebene liegt ,zu überwinden, sodass das Verbindungsteil des Verbindungselements, welches bevorzugt zumindest teilweise auf der Höhe mindestens eines geeigneten Vorderkontakts einer benachbarten Solarzelle angeordnet werden kann, gegebenenfalls nach dem Biegen/Verbiegen bevorzugt zumindest teilweise auf mindestens einem geeigneten Vorderkontakt einer benachbarten Solarzelle ruhen kann und dass dadurch bevorzugt eine elektrische Verbindung zwischen den Verbindungsteil des Verbindungselements und dem geeigneten Vorderkontakt hergestellt werden kann. Dabei kann das Verbindungsteil des Verbindungselements, welches mit der Rückseite einer Solarzelle verbunden beziehungsweise verklebt ist, gegebenenfalls nach den Biegen/Verbiegen bevorzugt auf einem Vorderkontakt einer benachbarten Solarzelle ruhen und diesen demnach bevorzugt berühren. Durch das Biegen/Verbiegen beim elektrisch leitenden Verbinden des Verbindungsteils eines Verbindungselements, welches mit der Rückseite einer Solarzelle verbunden beziehungsweise verklebt ist, mit dem Vorderkontakt einer benachbarten Solarzelle kann trotz einer planen Gestaltung des Verbindungselements im Querschnitt ein annähernd S-förmiger Verlauf beziehungsweise eine annähernd S-förmige Stufe entstehen. Durch eine nicht plane Gestaltung können dabei zum Beispiel Spannungen, die durch das Verbiegen des Verbindungselements beziehungsweise des Verbindungsteils des Verbindungselements gegebenenfalls auftreten können, möglichst reduziert werden. Insbesondere kann die Gestaltung und bevorzugterweise die nicht plane Gestaltung des Verbindungselements dabei zum Beispiel mindestens einen Knick beziehungsweise mindestens eine Stufe oder eine im Querschnitt annähernd S-förmige Stufe, die im Querschnitt dem Verlauf einer Sigmoidfunktion ähnelt, aufweisen, um den Höhenunterschied zwischen der Ebene der Rückseite einer Solarzelle mit einem oder mehreren Vorderkontakt(en), insbesondere zum Beispiel einer H-Bar-Siliziumsolarzelle, und der Ebene eines Vorderkontakts einer weiteren benachbarten Solarzelle mit einem oder mehreren Vorderkontakt(en), insbesondere zum Beispiel einer benachbarten H-Bar-Siliziumsolarzelle, zu überbrücken und eine Verschaltung der Rückseite einer Solarzelle mit einem oder mehreren Vorderkontakt(en) und insbesondere zum Beispiel einer H-Bar-Siliziumsolarzelle und mindestens eines Vorderkontakts einer weiteren benachbarten Solarzelle mit einem oder mehreren Vorderkontakt(en), insbesondere zum Beispiel einer benachbarten H-Bar-Siliziumsolarzelle, durch das Verbindungselement zu erlauben. Dabei können durch die Verwendung von Solarzellen mit einem oder mehreren Vorderkontakt(en), insbesondere zum Beispiel von normalen H-Bar-Siliziumsolarzellen, die Kosten zur Fertigung des Solarmoduls reduziert werden, da diese Solarzellentypen in großen Mengen bequem hergestellt werden können.

Darüber hinaus kann die Gestaltung des Verbindungselements in einer Ausführungsform der vorliegenden Erfindung mindestens ein Element zum Spannungsabbau umfassen, um gegebenenfalls dazu beizutragen Spannungen zu reduzieren, die bei der Verbindung eines Verbindungelements und einer Solarzelle zum Beispiel aufgrund einer gegebenenfalls leicht ungenauen Platzierung und/oder der Unterschiede zwischen den thermischen Ausdehnungskoeffizienten der Verbindungselemente und der Solarzellen, auftreten können. Insbesondere können Spannungen zum Beispiel der Unterschiede zwischen den thermischen Ausdehnungskoeffizienten der Verbindungselemente und der Solarzellen auftreten, wenn Solarzelle und Verbindungselement zum Beispiel beim Löten erwärmt werden und miteinander verbunden wieder abkühlen. Ein Element zum Spannungsabbau, kann dabei jegliches Element sein, das es ermöglicht Spannungen, die beim Verbinden und/oder elektrisch leitenden Verbinden des Verbindungselements (insbesondere des Basisteils und/oder des Verbindungsteils des Verbindungselements) mit einer Solarzelle beziehungsweise im Verbund von Verbindungselement und Solarzelle auftreten können gegenenfalls zu reduzieren. Insbesondere kann es sich bei einem Element zum Spannungsabbau, um ein mehr oder weniger federndes beziehungsweise bewegliches Element handeln, welches dazu beitragen kann Spannungen gegebenenfalls federnd und/oder durch leicht Bewegung/Verschiebung aufzunehmen beziehungsweise auszugleichen und somit zu reduzieren. Ein Element zum Spannungsabbau kann dabei bevorzugterweise als integraler Teil der Gestaltung eines Verbindungselements an jeder Stelle vorgesehen sein, die es ermöglicht, Spannungen zu reduzieren. Ein Element zum Spannungsabbau kann dabei bevorzugterweise am Übergang zwischen dem Basisteil und dem Verbindungsteils des Verbindungselements beziehungsweise innerhalb des Basisteils und/oder der Verbindungsteils des Verbindungselements vorgesehen sein. Durch mindestens ein Element zum Spannungsabbau kann das Risiko der Beschädigung der Solarzellen weiter reduziert werden.

Die Platzierung der Solarzellen und/oder der Verbindungselemente und/oder der Verbünde aus je einer Solarzelle und je einem damit verbundenen Verbindungselement kann dabei insbesondere zum Beispiel die Anordnung innerhalb eines Solarzellstring, eines Solarmoduls, eines Rahmens eines Solarmoduls, eines Aufbaus des Solarmoduls oder auf einer Rückplatte des Solarmoduls sein, welches bevorzugt zum Beispiel vor/bei der Herstellung eines Solarzellstrings und/oder eines Solarmoduls erfolgen kann.

Erfindungsgemäß kann ein Verbindungselement im Sinne der Erfindung zum Beispiel so gestaltet sein, dass die Gestaltung des Verbungselements es ermöglicht, dass durch ein Verbindungselement jeweils immer nur zwei benachbarte Solarzellen miteinander verschaltet werden. Dabei können durch die Verwendung von mehreren Verbindungselementen und/oder von mehreren Verbünden aus je einer Solarzelle und einem damit verbunden Verbindungselement durchaus mehr als zwei Solarzellen miteinander verschaltet werden, wobei durch ein Verbindungselement jeweils immer zwei benachbarte Solarzelle miteinander verschaltet werden. Eine Verschaltung im Sinne der vorliegenden Erfindung kann dabei vorliegen, wenn die benachbarten Solarzellen elektrisch leitend miteinander verbunden sind. Bevorzugterweise kann eine Verschaltung im Sinne der vorliegenden Erfindung vorliegen, wenn die Solarzellen elektrisch leitend miteinander verbunden in Serie beziehungsweise in Reihe geschaltet sind. Dazu kann der Pluspol jeder Solarzelle bevorzugt zum Beispiel mit dem Minuspol einer benachbarten Solarzelle, bevorzugt ohne Abzweigung, elektrisch leitend verbunden werden. Dadurch kann durch eine Reihenschaltung oder Serienschaltung mehrerer Solarzellen bei richtiger Polarität eine höhere Spannung erzeugt werden. Bevorzugterweise können dabei alle Solarzellen, die zum Beispiel eine Reihe/Zeile oder eine Spalte der in einem Solarmodul angeordneten Solarzellen darstellen, durch das erfindungsgemäße Verfahren über Verbindungselemente in Reihe oder in Serie geschaltet sein. Dabei können zum Beispiel jedes Paar benachbarter Solarzellen und/oder gegebenenfalls darüber hinaus zum Beispiel auch alle Solarzellen eines Solarmoduls jeweils in Reihe oder in Serie geschaltet sein. Alternativ kann eine Verschaltung im Sinne der vorliegenden Erfindung auch vorliegen, wenn die Solarzellen elektrisch leitend miteinander verbunden und parallel geschaltet sind. Dabei können insbesondere mehrere Solarzellstrings beziehungsweise Solarzellketten gegebenenfalls zum Beispiel durch erfindungsgemäße Verbindungselemente parallel geschaltet werden, um bestimmte zum Beispiel Strom-Spannungsparameter zu erreichen. Der Pluspol und der Minuspol einer Solarzelle eines Solarzellstrings beziehungsweise einer Solarzellkette können dabei bevorzugt durch jeweils ein Verbindungselement respektive mit dem Pluspol und dem Minuspol einer bevorzugt benachbarten Solarzelle eines weiteren Solarzellstrings beziehungsweise einer weiteren Solarzellkette verbunden werden, um eine Parallelschaltung zu ermöglichen. Zudem können auch sogenannte "By-pass"-Dioden verwendet werden, um beim Ausfall eines Modulteils beziehungsweise eines Solarzellstrings, diesen Teil gegebenenfalls zu umgehen, um das Risiko eines Totalausfalls des Moduls oder eines Spannungsabfalls zu reduzieren.

Benachbarte Solarzellen im Sinne der vorliegenden Erfindung können dabei Solarzellen sein, die bevorzugt zum Beispiel bei/nach der Platzierung zur Herstellung eines Solarmoduls mindestens über eine Seite aneinander angrenzend angeordnet sind. Bevorzugterweise können benachbarte Solarzellen im Sinne der vorliegenden Erfindung Solarzellen sein, die in einem Solarmodul mindestens über eine Seite aneinander angrenzend angeordnet sind. Dabei können die benachbarten Solarzellen mindestens über eine Seite aneinander angrenzend jedoch auch auf Abstand zueinander beziehungsweise gegebenenfalls durch einen Abstand getrennt angeordnet sein, wobei sie gegebenenfalls nach einem Zusammenschieben zum Überbrücken des Abstands bevorzugt direkt mindestens über eine Seite aneinander angrenzen können. Zudem können benachbarte Solarzellen im Sinne der vorliegenden Erfindung Solarzellen sein, die durch für Abstand und/oder Halt sorgende Elemente, wie zum Beispiel Abstandhalter, Klammern. Halteelemente, Rahmen, Rahmenteile oder Schienen beziehungsweise Halteschienen getrennt, jedoch über die für Abstand und/oder Halt sorgenden Elemente mindestens über eine Seite aneinander angrenzend angeordnet sind.

Durch das Verbinden beziehungsweise Verkleben eines Verbindungselements beziehungsweise des Basisteils eines Verbindungselements mit der Rückseite einer Solarzelle kann ein Verbund aus jeweils einer Solarzelle und einem Verbindungselement entstehen, welcher bevorzugterweise ein eigenständiges greifbares und/oder manipulierbares und/oder ausrichtbares und/oder platzierbares Teil darstellen kann. Ein Verbund aus je einer Solarzelle und je einem Verbindungselement kann dabei insbesondere ein Verbund aus jeweils einer Solarzelle und jeweils einem bevorzugt über die Rückseite damit verbundenen Verbindungselement sein. Eine Solarzelle, welche mit einem Verbindungselement und insbesondere einem Basisteil des Verbindungselements verbunden beziehungsweise verklebt ist, kann dabei im Sinne der vorliegenden Erfindung bevorzugt zum Beispiel über ihre Rückseite mit dem Verbindungselement und insbesondere mit dem Basisteil des Verbindungselements verbunden oder verklebt sein. Zudem kann ein Verbindungselement und insbesondere das Basisteil eines Verbindungselements, welches mit einer Solarzelle verbunden beziehungsweise verklebt ist, im Sinne der vorliegenden Erfindung bevorzugt zum Beispiel mit der Rückseite der Solarzelle verbunden beziehungsweise verklebt sein. Der Verbund ist dabei mechanisch widerstandsfähiger als eine Solarzelle beziehungsweise ein Siliziumwafer, da das Verbindungselement die Solarzelle beziehungsweise den Siliziumwafer jeweils unterstützt. Dadurch kann das Risiko einer Beschädigung der Solarzellen beziehungsweise der Siliziumwafer stark reduziert werden. Darüber hinaus kann die Herstellung eines Solarmoduls vereinfacht werden, da die Solarzellen als Verbund zusammen mit jeweils einem Verbindungselement transportiert und/oder gegriffen und/oder manipuliert und/oder ausgerichtet und/oder platziert werden können.

Zur Verschaltung der Solarzellen können dabei bevorzugt zum Beispiel lediglich jeweils Verbünde aus jeweils einer Solarzelle und jeweils einem damit verbundenen Verbindungsteil transportiert und/oder gegriffen und/oder gedreht und/oder ausgerichtet und/oder platziert und/oder manipuliert werden. Ein Verbund ist dabei mechanisch widerstandsfähiger als eine Solarzelle beziehungsweise ein Siliziumwafer, da das Verbindungselement die Solarzelle beziehungsweise den Siliziumwafer jeweils unterstützt. Dadurch kann das Risiko einer Beschädigung der Solarzellen beziehungsweise der Siliziumwafer stark reduziert werden. Darüber hinaus kann die Herstellung eines Solarmoduls vereinfacht werden, da die Solarzellen als Verbund zusammen mit jeweils einem Verbindungselement transportiert und/oder gegriffen und/oder manipuliert und/oder ausgerichtet und/oder platziert werden können.

Vor/bei der Platzierung der Solarzellen und/oder der Verbindungselemente und/oder der Verbünde aus je einer Solarzelle und je einem Verbindungselement kann bevorzugt jeweils ein Teil des Verbindungselementes und insbesondere das Verbindungsteil eines Verbindungselements, welches mit der Rückseite einer Solarzelle verbunden beziehungsweise verklebt wurde, bereits zumindest teilweise auf Höhe mindestens eines bevorzugt geeigneten Vorderkontakts einer zweiten benachbarten Solarzelle angeordnet werden, sodass zur Verschaltung der Solarzellen nur noch eine elektrische Verbindung zwischen diesem Teil des Verbindungselements und der zweiten benachbarten Solarzelle hergestellt werden muss. Ein geeigneter Vorderkontakt im Sinne der vorliegenden Erfindung kann dabei zum Beispiel jeder Vorderkontakt sein, der eine Verschaltung der beiden Solarzellen ermöglicht. Ein geeigneter Vorderkontakt im Sinne der vorliegenden Erfindung kann dabei bevorzugt jeder Vorderkontakt einer Solarzelle sein, der über ein Verbindungselement bevorzugt mit der Rückseite einer benachbarten Solarzelle verbunden eine Verschaltung der beiden Solarzellen ermöglicht. Weiter bevorzugt kann ein geeigneter Vorderkontakt dabei zum Beispiel insbesondere jeder Vorderkontakt einer Solarzelle sein, der über ein Verbindungselement bevorzugt mit der Rückseite einer benachbarten Solarzelle verbunden eine Serien- oder Reihen-Verschaltung der beiden Solarzellen ermöglicht. Alternativ kann ein geeigneter Vorderkontakt gegebenenfalls zum Beispiel auch jeder Vorderkontakt einer Solarzelle sein, der über ein Verbindungselement bevorzugt mit der Rückseite einer benachbarten Solarzelle verbunden eine Parallelschaltung der beiden Solarzellen und/oder bevorzugterweise eine Parallelschaltung von mindestens zwei Solarzellstrings beziehungsweise Solarzellketten ermöglicht.

Dabei können die Solarzellen und/oder die damit verbundenen beziehungsweise verklebten Verbindungselemente und/oder der Verbünde aus jeweils einer Solarzelle und jeweils einem damit verbunden Verbindungselement gegebenenfalls zum Beispiel bevorzugt vor und/oder bei der Platzierung der Solarzellen und/oder der damit verbundenen Verbindungselements und/oder jeweils der Verbünde aus jeweils einer Solarzelle und jeweils einem damit verbunden Verbindungselement so ausgerichtet werden, dass nach dem Platzieren mindestens ein Teil jedes/des Verbindungselements und insbesondere jedes/des Verbindungsteils jeweils zumindest teilweise auf mindestens einem geeigneten Vorderkontakt einer benachbarten Solarzelle ruht beziehungsweise dass jeweils ein Teil des/jedes Verbindungselementes und insbesondere des Verbindungsteils des/jedes Verbindungselements, welches bevorzugt über sein Basisteil mit der Rückseite einer Solarzelle verbunden beziehungsweise verklebt wurde, zumindest bereits auf Höhe eines geeigneten Vorderkontakts einer weiteren benachbarten Solarzelle angeordnet wird, sodass zur Verschaltung der Solarzellen nur noch eine elektrische Verbindung zwischen diesem Teil des Verbindungselements und der weiteren benachbarten Solarzelle hergestellt werden muss. Demnach kann das Verbindungsteil des Verbindungselements, welches mit der Rückseite einer Solarzelle verbunden beziehungsweise verklebt ist, bevorzugt auf einem Vorderkontakt einer benachbarten Solarzelle ruhen und diesen somit bevorzugt berühren. Auf der Höhe eines (geeigneten) Vorderkontakts angeordnet kann dabei insbesondere zum Beispiel in der Nähe dieses Vorderkontakts beziehungsweise in unmittelbarer Nähe dieses Vorderkontakts und/oder über diesen Vorderkontakt platziert bedeuten, wobei ein direkter Kontakt und/oder eine direkte Berührung des Vorderkontakts jedoch möglich jedoch nicht erforderlich ist. Vor/bei der Platzierung einer Solarzelle kann die Ausrichtung der Solarzelle und des damit verbundenen beziehungsweise verklebten Verbindungselements bevorzugterweise berücksichtigt und gegebenenfalls angepasst werden, sodass eine Solarzelle und das damit verbundene beziehungsweise verklebte Verbindungselement vor/bei der Platzierung so ausgerichtet werden, dass jeweils ein Teil des Verbindungselementes, welches mit der Rückseite einer Solarzelle verbunden beziehungsweise verklebt wurde, bereits auf Höhe eines geeigneten Vorderkontakts einer zweiten benachbarten Solarzelle angeordnet wird, sodass zur Verschaltung der Solarzellen nur noch eine elektrische Verbindung zwischen diesem Teil des Verbindungselements und der weiteren benachbarten Solarzelle hergestellt werden muss. Gegebenenfalls können die Solarzellen und die damit verbundenen beziehungsweise verklebten Verbindungselemente bevorzugt vor/bei der Platzierung zum Beispiel durch eine oder mehrere Drehbewegungen so ausgerichtet werden, dass jeweils ein Teil des Verbindungselementes, welches mit der Rückseite einer Solarzelle verbunden beziehungsweise verklebt wurde, bereits auf Höhe eines geeigneten Vorderkontakts einer weiteren benachbarten Solarzelle angeordnet wird.

In einer bevorzugten Ausführungsform der vorliegenden Erfindung kann das elektrisch leitende Verbindungselement elektrisch leitend ausgestaltet sein. Dabei kann das erfindungsgemäße Verbindungselement zum Beispiel eine Metallfolie oder eine Metallschicht und/oder eine Polymerfolie. Darüber hinaus kann das Verbindungselement auch aus einer Metallfolie bestehen. Durch eine Metallfolie oder eine Metallschicht kann insbesondere zum Beispiel ermöglich werden, dass die Verbindungselemente elektrisch leitend sein können. Eine Metallfolie oder eine Metallschicht kann dabei zum Beispiel dafür sorgen, dass die Verbindungselemente elektrischen Strom ausreichend gut leiten, um zwei benachbarte Solarzellen elektrisch miteinander zu verbinden und insbesondere zum Beispiel zu verschalten. In einer bevorzugten Ausführungsform der vorliegenden Erfindung kann das elektrisch leitende Verbindungselement zum Beispiel aus einer Metallfolie gefertigt werden, sodass das elektrisch leitende Verbindungselement bevorzugt aus einer Metallfolie mit einer bestimmten erfindungsgemäßen Gestaltung besteht. Alternativ kann das elektrisch leitende Verbindungselement zum Beispiel aus einem polymerischen Substrat, wie zum Beispiel einer Polymerfolie oder einer Polymerplatte, mit einer Metallschicht beziehungsweise mit einer Metallbeschichtung gefertigt werden, sodass das elektrisch leitende Verbindungselement aus einem polymerischen Substrat mit einer Metallschicht und einer erfindungsgemäßen Gestaltung besteht. Das Polymer kann dabei bevorzugt zum Beispiel mechanisch ausreichend stabil sein und insbesondere formstabil und/oder widerstandsfähig und/oder Reißfest sein, um zur mechanischen Unterstützung der Solarzelle gegebenenfalls beizutragen und das Risiko einer Beschädigung der Solarzelle möglichst zu reduzieren. Durch ein derartiges erfindungsgemäßes Verbindungelement, welches eine Metallfolie oder eine Metallschicht und ein polymerisches Substrat umfasst, kann der Schutz der Solarzelle beziehungsweise des Siliziumwafers verbessert werden, da die Solarzellen beziehungsweise die Siliziumwafer durch die Metallfolie oder die Metallschicht und das polymerische Substrat mechanisch verstärkt beziehungsweise unterstützt werden können. Das Risiko einer Beschädigung der Solarzellen beziehungsweise der Siliziumwafer durch die verschiedenen Fertigungsschritte, insbesondere zum Beispiel Manipulations-, Greif- oder Transportschritte, welche zur Herstellung eines Solarmodul erforderlich sind, lässt sich somit erheblich reduzieren.

In einer bevorzugten Ausführungsform der vorliegenden Erfindung kann das elektrisch leitende Verbindungselement zudem formstabil sein. Formstabil im Sinne der vorliegenden Erfindung kann dabei bedeuten, dass das Verbindungselement seine erfindungsgemäße Gestaltung beziehungsweise Form bewahrt. Formstabil im Sinne der vorliegenden Erfindung kann dabei bevorzugt bedeuten, dass das Verbindungselement, zum Beispiel nachdem es einmal entsprechend der gewünschten Gestaltung in Form gebracht wurde, diese Form beziehungsweise Gestaltung bewahrt. Insbesondere kann das Verbindungselement seine Form beziehungsweise Gestaltung dabei bevorzugt zum Beispiel trotz der zum Herstellen eines Solarmoduls erforderlichen Manipulations-, Greif-. Klebe-, Platzier-, Löt- und Transportschritte bewahren. Durch Verbindungselemente, welche formstabil sind, kann das Risiko einer Verformung und Beschädigung der Gestaltung der Verbindungselemente durch einen zum Herstellen eines Solarmoduls erforderlichen Arbeitsschritt, zum Beispiel einen Manipulations-, Greif-, Klebe-, Platzier-, Löt- und Transportschritt, reduziert werden. Dabei können benachbarte Solarzellen erfindungsgemäß besonders bequem und zuverlässig gemäß dem erfindungsgemäßen Verfahren durch nicht beschädigte Verbindungselemente beziehungsweise durch Verbindungselemente mit einer nicht während eines Arbeitsschritts zur Fertigung eines Solarmoduls verformten Gestaltung einfach und schnell verschaltet werden.

In einer bevorzugten Ausführungsform der vorliegenden Erfindung kann das elektrisch leitende Verbindungselement eine Metallfolie oder eine Metallschicht mit einer Dicke von zwischen 0,005 mm und 4 mm, bevorzugt zwischen 0,01 mm und 2 mm, weiter bevorzugt zwischen 0,05 mm und 1 mm, weiter bevorzugt zwischen 0,1 mm und 0,6 mm, weiter bevorzugt zwischen 0,1 mm und 0,4 mm, besonders bevorzugt zwischen 0,15 mm und 0,3 mm umfassen. Durch eine Metallfolie oder eine Metallschicht mit einer solchen Dicke kann die Formstabilität der Verbindungselemente erhöht werden. Je dicker die Metallfolie oder die Metallschicht ist, desto formstabiler kann das Verbindungselement dabei sein. Durch Verbindungselemente, welche formstabiler sind, kann das Risiko einer Verformung und Beschädigung der Gestaltung der Verbindungselemente durch einen zum Herstellen eines Solarmoduls erforderlichen Arbeitsschritt, zum Beispiel einen Manipulations-, Greif-, Klebe-, Platzier-, Löt- und/oder Transportschritt, reduziert werden. Darüber hinaus kann durch eine Metallfolie oder eine Metallschicht mit einer solchen Dicke dabei auch der Schutz der Solarzelle beziehungsweise der Siliziumwafer verbessert werden, da die Solarzellen beziehungsweise die Siliziumwafer mechanisch besser verstärkt und unterstützt werden können. Je dicker die Metallfolie oder die Metallschicht ist, desto besser können die Solarzellen beziehungsweise die Siliziumwafer mechanisch verstärkt und unterstützt werden. Das Risiko einer Beschädigung der Solarzellen beziehungsweise der Siliziumwafer durch die verschiedenen Fertigungsschritte, insbesondere zum Beispiel Manipulations-, Greif- oder Transportschritte, welche zur Herstellung eines Solarmodul erforderlich sind, lässt sich somit erheblich reduzieren.

In einer bevorzugten Ausführungsform der vorliegenden Erfindung kann das elektrisch leitende Verbindungselement und insbesondere das Basisteil des Verbindungselements bevorzugt zum Beispiel zwischen 5 % und 100 %, weiter bevorzugt zwischen 10 % und 97,5 %, weiter bevorzugt zwischen 20 % und 95 %, weiter bevorzugt zwischen 30 % und 90 %, weiter bevorzugt zwischen 40 % und 85 %, weiter bevorzugt zwischen 50 % und 80 %, weiter bevorzugt zwischen 55 % und 75 %, weiter bevorzugt 60 % bis 70% der Fläche der Rückseite der Solarzelle, mit welcher es verbunden beziehungsweise verklebt wird, bedecken beziehungsweise abdecken. Dabei kann das elektrisch leitende Verbindungselement und insbesondere das Basisteil des Verbindungselements zum Beispiel insbesondere mindestens 5 %, bevorzugt mindestens 10%, weiter bevorzugt mindestens 15 %, weiter bevorzugt mindestens 20 %, weiter bevorzugt mindestens 25 %, weiter bevorzugt mindestens 30 %, weiter bevorzugt mindestens 35 %, weiter bevorzugt mindestens 40 %, weiter bevorzugt mindestens 45 %, noch weiter bevorzugt mindestens 50 %, noch weiter bevorzugt mindestens 55 %, noch weiter bevorzugt mindestens 60 %, noch weiter bevorzugt mindestens 65 %, noch weiter bevorzugt mindestens 70 %, noch weiter bevorzugt mindestens 75 %, noch weiter bevorzugt mindestens 80 %, noch weiter bevorzugt mindestens 85 %, noch weiter bevorzugt mindestens 90 %, noch weiter bevorzugt mindestens 92,5 %, noch weiter bevorzugt mindestens 95 %, noch weiter bevorzugt mindestens 97,5 %, noch weiter bevorzugt mindestens 99 %, noch weiter bevorzugt mindestens 100 % der Fläche der Rückseite der Solarzelle, mit welcher es verbunden beziehungsweise verklebt wird, bedecken beziehungsweise abdecken. Dadurch kann die Solarzelle beziehungsweise der Siliziumwafer durch das Verbindungselement und insbesondere durch das Basisteil des Verbindungselements bevorzugt zum Beispiel auf einer möglichst großen Fläche mechanisch verstärkt und unterstützt werden. Je größer die vom einem Verbindungselement und insbesondere von einem Basisteil des Verbindungselements bedeckte Fläche der Rückseite einer Solarzelle ist, welche mit dem Verbindungselement und insbesondere mit dessen Basisteil verbunden beziehungsweise verklebt ist, desto besser kann die Solarzelle beziehungsweise der Siliziumwafer dabei durch das Verbindungselement mechanisch verstärkt und unterstützt werden. Das Risiko einer Beschädigung der Solarzellen beziehungsweise der Siliziumwafer durch die verschiedenen Fertigungsschritte, insbesondere zum Beispiel Manipulations-, Greif- oder Transportschritte, welche zur Herstellung eines Solarmodul erforderlich sind, lässt sich somit erheblich reduzieren.

In einer Ausführungsform der vorliegenden Erfindung kann der Zwischenraum zwischen bevorzugt elektrisch leitenden Verbindungspunkten/Verbindungsflächen beziehungsweise zum Beispiel den Lötpunkten/Lötflächen oder elektrisch leitenden Klebepunkten/Klebeflächen gegebenenfalls mit mindestens einem elektrisch nicht leitenden Material insbesondere zum Beispiel einem Polymermaterial beziehungsweise mindestens einem nicht leitenden Adhäsiv ausgefüllt werden, welcher /welches bevorzugterweise ebenfalls eine Verbindung zwischen einem Verbindungselemente und einer Solarzelle herstellt, um eine Solarzelle auf einer möglichst großen Fläche durch das Verbindungselement zu unterstützen.

In einer bevorzugten Ausführungsform der vorliegenden Erfindung kann ein elektrisch leitendes Verbindungselement, bevorzugt zum Beispiel mit einem elastischen elektrisch leitenden Kleber und/oder mit einer Kombination aus einem elastischen Material, bevorzugt einem elastischen Kleber, und einem elektrisch leitenden Kleber oder einem niedrig schmelzenden Lot, mit der Rückseite der ersten Solarzelle verbunden beziehungsweise verklebt werden. Das elastische Material beziehungsweise der elastische Kleber kann dabei gegebenenfalls auch nicht elektrisch leitend sein, wenn es/er bevorzugt zum Beispiel zusammen mit einem elektrisch leitenden Kleber oder einem niedrig schmelzenden Lot verwendet wird. Der Zwischenraum zwischen den bevorzugt elektrisch leitenden Verbindungspunkten/Verbindungsflächen beziehungsweise zum Beispiel den Lötpunkten/Lötflächen oder den elektrische leitenden Klebepunkten/Klebeflächen kann dabei demnach gegebenenfalls mit mindestens einem elastischen gegebenenfalls nicht leitendem Material beziehungsweise mindestens einem elastischen gegebenenfalls nicht leitenden Adhäsiv ausgefüllt werden, welcher /welches bevorzugterweise ebenfalls eine Verbindung zwischen einem Verbindungselemente und einer Solarzelle herstellt, um eine Solarzelle auf einer möglichst großen Fläche durch das Verbindungselement zu unterstützen und bevorzugt zudem gegebenenfalls auftretende oder vorhandene Spannungen durch eine gewisse Elastizität reduziert oder zumindest teilweise ausgleicht. Alternativ kann dazu zum Verbinden des Verbindungselements und insbesondere dessen Basisteils mit der Rückseite einer Solarzelle auch ein einziger elastischer elektrisch leitender Kleber verwendet werden, der sowohl elastisch als auch elektrisch leitend ist. Ein elastisches Material im Sinne der vorliegenden Erfindung kann bevorzugt zum Beispiel ein Material darstellen, welches unter Krafteinwirkung seine Form verändert und bei Wegfall der Krafteinwirkung wieder in seinen Ursprungszustand zurückkehren kann. Dabei können zum Beispiel Polymere und insbesondere Elastomere oder deren Copolymere und/oder Mischungen davon elastische Materialien darstellen. Sofern das Verbindungselement und insbesondere das Basisteil des Verbindungselements mit einer Kombination aus einem elastischen Material, bevorzugt einem elastischen Kleber, und einem elektrisch leitenden Kleber oder einem niedrig schmelzenden Lot mit der Rückseite der Solarzelle verbunden beziehungsweise verklebt wird, können mit dem elektrisch leitenden Kleber oder dem niedrig schmelzenden Lot zum Beispiel auch lediglich punktuell elektrisch leitende Verbindungspunkte insbesondere elektrisch leitende Klebepunkte oder Lötpunkte gesetzt werden, während der Zwischenraum zwischen den elektrisch leitenden Verbindungspunkte insbesondere den elektrisch leitenden Klebepunkten oder Lötpunkten gegebenenfalls mit einem elastischen Material aufgefüllt werden kann. Ein elastischer elektrisch leitender Kleber kann dabei zum Beispiel ein Kleber sein, der sowohl elastische Teilchen, zum Beispiel Elastomer-, Gummi-, Kautschuk-, Latex-, Styrol-Butadien-Kautschuk-, Butadien-Acrylnitril-Kautshuk-, Polyurethan-, Polyvinylbutyral- , Polyisopren-, Silikongummi-, Polychloropren-, Polydimethyltbutadien-, Polybutadien-Teilchen oder Mischungen davon sowie zum Beispiel elastische Teilchen, die insbesondere zum Beispiel Styrolacrylat, Ethylen Vinylacetat, Acrylsäure oder Methacrylsäure, Acrylsäure- oder Methacrylsäureester, Styrol, Butadien, Vinylbutyral, Dimethylbutadien, Isopren, Chloropren Siloxane, Dimethylsiloxan, Acrylnitril, Acrylate oder Methacrylate oder Copolymere sowie Mischungen davon enthalten, als auch elektrische leitende Teilchen, zum Beispiel Gold-, Silber-, Aluminium-, Nickel-, Kupfer-, Silber-, Nickel- und/oder Kohlenstoff-Teilchen oder Mischungen/Legierungen davon, umfassen. Ein elastisches Material kann dabei zum Beispiel ein Elastomer, Gummi, Kautschuk, Latex, Styrol-Butadien-Kautschuk, Butadien-Acrylnitril-Kautshuk, Polyurethan, Polyvinylbutyral, Polyisopren, Silikongummi, Polychloropren, Polydimethyltbutadien, Polybutadien oder Mischungen davon sowie zum Beispiel elastische Materialien, die insbesondere zum Beispiel Styrolacrylat, Ethylen Vinylacetat, Acrylsäure oder Methacrylsäure, Acrylsäure- oder Methacrylsäureester, Styrol, Butadien, Vinylbutyral, Dimethylbutadien, Isopren, Chloropren Siloxane, Dimethylsiloxan, Acrylnitril, Acrylate oder Methacrylate oder Copolymere davon sowie Mischungen davon enthalten, umfassen. Durch die Verwendung eines elastischen elektrisch leitenden Klebers oder einer Kombination aus einem elastischen Material und einem elektrisch leitenden Kleber oder einem niedrig schmelzendem Lot können Spannungen, die durch Unterschiede der Wärmeausdehnungskoeffizienten der Solarzellen und der Verbindungselemente insbesondere unter Wärmeeinwirkung und/oder beim Abkühlen nach einer Wärmeeinwirkung auftreten können, gegebenenfalls über das elastische Material abgebaut werden. Dadurch kann das Risiko einer Beschädigung der mit den Verbindungselementen verbundenen oder verklebten Solarzellen beziehungsweise Siliziumwafern durch Spannungen, die unter Wärmeeinwirkung und/oder beim Abkühlen nach einer Wärmeeinwirkung entstehen können, reduziert werden, da Spannungen zum Beispiel über eine bevorzugt befristete leichte Verformung des elastischen Materials beziehungsweise des elastischen Klebers abgebaut werden können.

In einer bevorzugten Ausführungsform der vorliegenden Erfindung kann das elektrisch leitende Verbindungselement mindestens ein Basisteil bevorzugt genau ein Basisteil, welches mit der Rückseite der ersten Solarzelle zum Beispiel vollflächig oder bevorzugt zumindest teilflächig beziehungsweise teilweise und/oder punktuell elektrisch leitend verbunden beziehungsweise verklebt wird, und mindestens ein Verbindungsteil, welches sich über das Basisteil hinaus erstreckt, umfassen. Das Basisteil kann dabei zum Beispiel jede beliebige Form aufweisen. Bevorzugterweise kann das Basisteil eines Verbindungselements jedoch eine Form aufweisen, die der Form der Solarzelle und/oder des Siliziumwafers beziehungsweise der Rückseite der Solarzelle und/oder des Siliziumwafers entspricht. Insbesondere kann das Basisteil dabei zum Beispiel eine quadratische, rechteckige oder runde Form aufweisen. Zusätzlich zu einem Basisteil, welches mit der Rückseite einer ersten Solarzelle verbunden beziehungsweise verklebt werden kann, kann das Verbindungselement zum Beispiel auch mindestens ein Verbindungsteil umfassen, das sich über das Basisteil hinaus erstreckt, wobei mindestens ein Teil jedes Verbindungsteils des Verbindungselements, bevorzugt zum Beispiel zumindest teilweise auf der Höhe eines geeigneten Vorderkontakts, einer weiteren benachbarten Solarzelle angeordnet und/oder vorgesehen werden kann. Ein Verbindungsteil des Verbindungselements kann dabei zum Beispiel mindestens eine Nase, bevorzugt zum Beispiel insbesondere mindestens eine quadratische oder rechteckige Nase beziehungsweise mindestens einen Streifen beziehungsweise mindestens einen bevorzugt rechteckigen und/oder mindestens zwei bevorzugt mehr als zwei Segmente umfassende Streifen umfassen. Bei entsprechender Ausrichtung des Verbindungselements und der Solarzelle, deren Rückseite mit dem Verbindungselement verbunden beziehungsweise verklebt ist, kann das Verbindungsteil oder mindestens ein Teil insbesondere zum Beispiel mindestens ein Streifen und/oder ein Steg des Verbindungsteils des Verbindungselements bevorzugt zumindest teilweise auf der Höhe eines geeigneten Vorderkontakts einer weiteren benachbarten Solarzellen angeordnet und/oder vorgesehen werden. Dabei kann bevorzugt zum Beispiel das Verbindungsteil beziehungsweise mindestens ein Teil des Verbindungsteils des Verbindungselements, welches bevorzugt zum Beispiel über das Basisteil mit der Rückseite einer Solarzelle verbunden beziehungsweise verklebt ist, auf mindestens einem Vorderkontakt einer weiteren benachbarten Solarzelle ruhen beziehungsweise auf der Höhe mindestens eines Vorderkontakts einer weiteren benachbarten Solarzelle angeordnet sein und diesen gegebenenfalls zumindest teilweise berühren, sodass gegebenenfalls bereits durch Berührung mit dem Vorderkontakt eine elektrische Verbindung zwischen dem Verbindungsteil, des Verbindungselements, welches bevorzugt zum Beispiel über das Basisteil mit der Rückseite einer Solarzelle verbunden beziehungsweise verklebt ist, und dem Vorderkontakt einer weiteren benachbarten Solarzelle hergestellt werden kann. Mindestens ein Streifen des Verbindungsteils eines Verbindungselements kann dabei eine beliebige Form aufweisen. Bevorzugterweise kann ein Streifen des Verbindungsteils eines Verbindungselements jedoch zum Beispiel eine bevorzugt längliche rechteckige Form aufweisen. Alternativ kann mindestens ein Streifen des Verbindungsteils eines Verbindungselements jedoch zum Beispiel eine Form mit mindestens zwei bevorzugt jedoch mehr als zwei Segmenten und/oder mit mindestens einer Richtungsänderung aufweisen, wobei jedes Segment bevorzugt zum Beispiel eine rechteckige Form aufweisen kann. Einzelne Segmente können dabei zum Beispiel jeweils Abschnitte des Streifens sein, die sich insbesondere zum Beispiel durch ihre Ausrichtung, ihre Breite, ihre Länge und/oder ihre Dicke von mindestens einem angrenzenden Abschnitt eines Streifens eines Verbindungsteils eines Verbindungselements unterscheiden. Die Richtungsänderung(en) kann/können dabei bevorzugt zum Beispiel in der Ebene des Verbindungsteils eine Verbindungselements erfolgen. Mindestens eine Richtungsänderung im Verlauf mindestens eines Streifens des Verbindungsteils eines Verbindungselements kann dabei mindestens zwei bevorzugt mehr als zwei Segmente eines Streifens des Verbindungsteils dieses Verbindungselements definieren, die sich durch die Richtungsänderung im Verlauf des Streifens durch ihre Ausrichtung voneinander unterscheiden.

In einer bevorzugten Ausführungsform der vorliegenden Erfindung kann das erfindungemäße Verbindungselement zum Beispiel bevorzugt einteilig sein, wobei ein einteiliges Verbindungselement jeweils mindestens ein Basisteil und mindestens ein Verbindungsteil umfassen kann, die nicht aus getrennten Teilen bestehen sondern lediglich Abschnitte des einteiligen Verbindungselements darstellen. In einer alternativen Ausführungsform kann das Verbindungselement auch mehrteilig insbesondere zum Beispiel zwei- drei- oder vierteilig sein. In diesen Fall kann jedes mehrteilige Verbindungselement jeweils mindestens ein Basisteil und mindestens ein Verbindungsteil umfassen, die jeweils eigenständige Teile des Verbindungselements darstellen, welche gegebenenfalls zusammengefügt und/oder insbesondere zum Beispiel durch Löten oder Kleben verbunden werden können, um ein Verbindungselements zu erhalten.

In einer bevorzugten Ausführungsform der vorliegenden Erfindung kann das elektrisch leitende Verbindungselement zum Beispiel bevorzugt ein rechteckiges oder quadratisches Basisteil umfassen, welches mit der Rückseite der ersten Solarzelle elektrisch leitend verbunden beziehungsweise verklebt werden kann und bevorzugt der Form der Rückseite der Solarzelle entspricht, sodass die Rückseite der Solarzelle zum Beispiel weitgehend oder nahezu komplett beziehungsweise bevorzugt komplett vom Verbindungselement beziehungsweise vom Basisteil des Verbindungselements bedeckt und gegebenenfalls unterstützt werden kann, wobei zudem mindestens ein bevorzugt zum Beispiel zwischen 1 und 10, bevorzugt auf Abstand angeordnete gegebenenfalls rechteckige und/oder mindestens zwei Segmente umfassende Streifen, weiter bevorzugt zwischen 2 und 4, bevorzugt auf Abstand angeordnete gegebenenfalls rechteckige und/oder mindestens zwei Segmente umfassende Streifen, als Verbindungsteil vorgesehen sein kann/können. Der/die Streifen erstreckt/erstrecken sich dabei über das Basisteil des Verbindungselements, welches mit der Rückseite einer Solarzelle verbunden beziehungsweise verklebt werden kann, hinaus, sodass zum Beispiel bevorzugt zumindest ein Teil eines Streifens und/oder zumindest ein Teil jedes Streifens bevorzugt bei entsprechender Ausrichtung, zum Beispiel zumindest teilweise auf der Höhe eines geeigneten Vorderkontakts einer weiteren benachbarten Solarzelle, angeordnet sein kann und/oder dabei bevorzugt insbesondere zum Beispiel auf mindestens einem Vorderkontakt einer weiteren benachbarten Solarzelle ruhen kann. Dabei kann das Verbindungselement, welches bevorzugt zum Beispiel über das Basisteil mit der Rückseite einer Solarzelle verbunden beziehungsweise verklebt wird, bevorzugt so gestaltet beziehungsweise so in Form gebracht werden, dass es eine nicht plane Gestaltung aufweisen kann, wobei bevorzugt ein Knick beziehungsweise eine Stufe oder eine im Querschnitt annähernd S-förmige Stufe, die im Querschnitt dem Verlauf einer Sigmoidfunktion ähnelt, zum Beispiel am Übergang zwischen dem Basisteil und dem Verbindungsteil oder am Verbindungsteil beziehungsweise am Basisteil vorgesehen sein kann, sodass zum Beispiel zumindest ein Teil eines Streifens und/oder zumindest ein Teil jedes Streifens des Verbindungsteils des Verbindungselements, welches mit der Rückseite einer Solarzelle verbunden beziehungsweise verklebt ist, bei entsprechender Ausrichtung bevorzugt auf mindestens einem Vorderkontakt einer weiteren benachbarten Solarzelle ruhen und diesen gegebenenfalls zumindest teilweise berühren kann, sodass gegebenenfalls bereits durch Berührung mit dem Vorderkontakt eine elektrische Verbindung zwischen dem Verbindungsteil, des Verbindungselements, welches bevorzugt zum Beispiel über das Basisteil mit der Rückseite einer Solarzell verbunden beziehungsweise verklebt ist, und dem Vorderkontakt einer weiteren benachbarten Solarzellehergestellt werden kann. Dadurch kann eine besonders bequeme Verschaltung der benachbarten Solarzellen durch eine einfache elektrisch leitende Verbindung des Verbindungsteils des Verbindungelements, welches gegebenenfalls bereits mit der Rückseite einer Solarzelle verbunden beziehungsweise verklebt ist, und mindestens einem Vorderkontakt einer weiteren benachbarten Solarzelle ermöglicht werden, da das Verbindungsteil bereits zumindest teilweise auf der Höhe eines Vorderkontakts einer benachbarten Solarzelle angeordnet sein kann beziehungsweise bevorzugt zumindest teilweise auf mindestens einem Vorderkontakt einer benachbarten Solarzelle ruhen kann und diesen gegebenenfalls zumindest teilweise berühren kann, sodass über die elektrische Verbindung durch Berührung hinaus gegebenenfalls eine zusätzliche elektrische Verbindung zwischen einer Solarzelle, welche gegebenenfalls bereits mit der Rückseite einer Solarzelle verbunden beziehungsweise verklebt ist, und mindestens einem Vorderkontakt einer weiteren benachbarten Solarzelle zum Beispiel durch Löten, Laserlöten, Ultraschalllöten, Schweißen oder elektrisch leitendes Kleben sehr bequem und/oder gegebenenfalls insbesondere nach dem Platzieren der Solarzellen und/oder der Verbindungselemente und/oder der Verbünde aus einer Solarzelle und einem Verbindungselement ohne weitere Manipulation der Solarzellen und/oder der Verbindungselemente und/oder der Verbünde aus einer Solarzelle und einem Verbindungselement hergestellt werden kann. Alternativ dazu kann das Verbindungselement beziehungsweise das Verbindungsteil des Verbindungselements insbesondere bei einer planen Gestaltung des Verbindungselements zum Verbinden mit einem geeigneten Vorderkontakt einer benachbarten Solarzelle auch leicht gebogen/verbogen werden, um den Höhenunterschied zwischen der Rückseite der Solarzelle, welche mit dem Verbindungselement und insbesondere dem Basisteil des Verbindungselements verbunden beziehungsweise verklebt ist, und dem Vorderkontakt einer benachbarten Solarzelle, welcher nicht in der gleichen Ebene liegt zu überwinden, sodass das Verbindungsteil des Verbindungselements, welches bevorzugt zumindest teilweise auf der Höhe mindestens eines geeigneten Vorderkontakts einer benachbarten Solarzelle angeordnet werden kann, gegebenenfalls nach dem Biegen/Verbiegen bevorzugt zumindest teilweise auf mindestens einem geeigneten Vorderkontakt einer benachbarten Solarzelle ruhen kann und dass dadurch bevorzugt eine elektrische Verbindung zwischen den Verbindungsteil des Verbindungselements und dem geeigneten Vorderkontakt bequem hergestellt werden kann. Dabei kann die Gestaltung des Verbindungselements und insbesondere zum Beispiel die Länge und/oder Breite der Streifen und/oder deren Abstand und/oder der Verlauf der Streifen, die mindestens zwei Segmente umfassen, beziehungsweise der Verlauf und/oder die Ausrichtung der entsprechenden Segmente so gewählt werden, dass bevorzugt zumindest ein Teil mindestens eines Streifens zum Beispiel bei entsprechender Ausrichtung des Verbindungselements und der damit verbundenen beziehungsweise verklebten Solarzelle, bevorzugt auf einem Vorderkontakt einer weiteren benachbarten Solarzelle, bevorzugt auf einem Vorderkontakt insbesondere einem H-Bar-Vorderkontakt einer H-Bar-Solarzelle und insbesondere einer H-Bar-Siliziumsolarzelle, ruhen kann beziehungsweise auf der Höhe eines entsprechenden Vorderkontakts angeordnet sein kann und diesen gegebenenfalls zumindest teilweise bevorzugt jedoch möglichst größtenteils bedecken kann. Durch diese bevorzugte Gestaltung des Verbindungselements können Solarzellen und insbesondere Solarzellentypen die Vorderkontakte aufweisen, bevorzugt zum Beispiel H-Bar-Solarzellen beziehungsweise H-Bar-Siliziumsolarzellen, einfach und bequem mit dem erfindungsgemäßen Verfahren verschaltet werden, auch wenn die Rückseite der Solarzelle, welche mit dem Verbindungselement verbunden beziehungsweise verklebt ist, beim verwendeten Solarzelltyp gegebenenfalls nicht in einer Ebene mit dem Vorderkontakt einer weiteren benachbarten Solarzelle liegen kann. Des Weiteren kann durch diese bevorzugte Gestaltung des Verbindungselements die Rückseite einer Solarzelle, welche mit dem Verbindungselement verbunden beziehungsweise verklebt ist, gegebenenfalls mit dem Vorderkontakt einer weiteren benachbarten Solarzelle elektrisch leitend verbunden oder verschaltet werden, ohne die Vorderseite der Solarzellen, die gegebenenfalls einfallendem Licht zugewendet sind, stark zu verdecken. Somit wird die Stromproduktion der Solarzellen durch die Verschaltung möglichst wenig beeinflusst beziehungsweise beeinträchtigt.

In einer bevorzugten Ausführungsform der vorliegenden Erfindung kann das elektrisch leitende Verbindungselement zum Beispiel bevorzugt ein rechteckiges oder quadratisches Basisteil umfassen, welches mit der Rückseite der ersten Solarzelle elektrisch leitend verbunden beziehungsweise verklebt werden kann und bevorzugt der Form der Rückseite der Solarzelle entspricht, sodass die Rückseite der Solarzelle bevorzugt komplett vom Verbindungselement bedeckt werden kann, wobei zudem bevorzugt zum Beispiel mindestens zwei und/oder mehr als zwei und/oder alle gegebenenfalls, bevorzugt auf Abstand angeordnete Streifen, des Verbindungsteils, die gegebenenfalls vorgesehen sein können und sich über das Basisteil hinaus erstrecken können, wiederum bevorzugt zum Beispiel über mindestens einen Steg, weiter bevorzugt jedoch zum Beispiel über 2, 3, 4, 5, 6, 7 oder 8 Stege, miteinander verbunden sein können. Ein Steg kann dabei bevorzugterweise quer und bevorzugt annähernd rechtwinklig zu mindestens einem Streifen beziehungsweise mindestens einem Segment eines Streifens eines Verbindungsteils eines Verbindungselementes angeordnet sein. Ein Steg kann dabei bevorzugt zum Beispiel ein rechteckiges beziehungsweise längliches rechteckiges Element sein, welches quer und bevorzugt annähernd rechtwinklig zu mindestens einem Streifen beziehungsweise mindestens einem Segment eines Streifens eines Verbindungsteils eines Verbindungselementes angeordnet und damit verbunden sein kann. Ein Steg kann dabei zum Beispiel bevorzugt mindesten zwei Streifen des Verbindungsteils eines Verbindungselements miteinander verbinden oder alternativ bevorzugterweise zum Beispiel ein rechteckiges beziehungsweise längliches rechteckiges Element sein, welches gegebenenfalls quer und bevorzugt annähernd rechtwinklig von mindestens einem Streifen beziehungsweise mindestens einem Segment eines Streifens eines Verbindungsteils eines Verbindungselementes aus angeordnet sein und damit verbunden sein ohne diesen mit einem weiteren Streifen zu verbinden. Dabei können ausgehend von mindestens einem Streifen eines Verbindungsteils eines Verbindungselements bevorzugt 2, 3, 4, 5, 6, 7 oder 8 Stege vorgesehen sein. Der/die gegebenenfalls vorgesehene(n) Streifen des Verbindungsteils des Verbindungselements, die - sofern mindestens zwei auf Abstand angeordnete Streifen vorgesehen sind - über mindestens einen Steg, weiter bevorzugt, jedoch zum Beispiel über 2, 3, 4, 5, 6, 7 oder 8 Stege miteinander verbundenen sein können, erstecken sich dabei bevorzugt über das Basisteil des Verbindungselements, welches mit der Rückseite einer Solarzelle verbunden beziehungsweise verklebt ist, sodass zum Beispiel zumindest ein Teil eines Streifens und/oder eines Stegs und/oder zumindest ein Teil jedes Streifens und/oder zumindest ein Teil jedes Stegs bei entsprechender Ausrichtung bevorzugt zum Beispiel zumindest teilweise auf der Höhe eines geeigneten Vorderkontakts einer weiteren benachbarten Solarzelle angeordnet sein und/oder dabei insbesondere zum Beispiel zumindest teilweise auf mindestens einem Vorderkontakt einer weiteren benachbarten Solarzelle ruhen kann und diesen gegebenenfalls teilweise zumindest berühren kann, sodass gegebenenfalls bereits durch Berührung mit dem Vorderkontakt eine elektrische Verbindung zwischen dem Verbindungsteil, des Verbindungselements, welches bevorzugt zum Beispiel über das Basisteil mit der Rückseite einer Solarzell verbunden beziehungsweise verklebt ist, und dem Vorderkontakt einer weiteren benachbarten Solarzellehergestellt werden kann. Dabei ist das Verbindungselement, welches mit der Rückseite einer Solarzelle verbunden beziehungsweise verklebt wird, bevorzugt so gestaltet beziehungsweise so in Form gebracht, dass es eine nicht plane Gestaltung aufweisen kann, wobei bevorzugt ein Knick beziehungsweise eine Stufe oder eine im Querschnitt annähernd S-förmige Stufe, die im Querschnitt dem Verlauf einer Sigmoidfunktion ähnelt, zum Beispiel am Übergang zwischen dem Basisteil und dem Verbindungsteil oder am Basisteil beziehungsweise am Verbindungsteil vorgesehen sein kann, sodass zum Beispiel zumindest ein Teil eines Streifens und/oder zumindest ein Teil jedes Streifens und/oder zumindest ein Teil eines Stegs und/oder zumindest ein Teil jedes Stegs des Verbindungteils des Verbindungselements, welches mit der Rückseite einer Solarzelle verbunden beziehungsweise verklebt ist, bei entsprechender Ausrichtung bevorzugt zumindest teilweise auf mindestens einem Vorderkontakt einer weiteren benachbarten Solarzelle ruhen und diesen gegebenenfalls zumindest teilweise berühren kann, sodass gegebenenfalls bereits durch Berührung mit dem Vorderkontakt eine elektrische Verbindung zwischen dem Verbindungsteil, des Verbindungselements, welches bevorzugt zum Beispiel über das Basisteil mit der Rückseite einer Solarzell verbunden beziehungsweise verklebt ist, und dem Vorderkontakt einer weiteren benachbarten Solarzellehergestellt werden kann. Durch diese bevorzugte Gestaltung des Verbindungselements und insbesondere des Verbindungsteils können Solarzellen und insbesondere Solarzellentypen die Vorderkontakte aufweisen, bevorzugt zum Beispiel H-Bar-Solarzellen beziehungsweise H-Bar-Siliziumsolarzellen, einfach und bequem mit dem erfindungsgemäßen Verfahren verschaltet werden, auch wenn der die Rückseite der Solarzelle, welche mit dem Verbindungselement verbunden beziehungsweise verklebt ist, beim verwendeten Solarzelltyp gegebenenfalls nicht in einer Ebene mit dem Vorderkontakt einer weiteren benachbarten Solarzelle liegen kann. Bevorzugterweise kann/können der/die Steg(e) des Verbindungsteils des Verbindungselements, welches mit der Rückseite einer Solarzelle verbunden beziehungsweise verklebt ist, und gegebenenfalls mindestens zwei Streifen miteinander verbinden kann/können, dabei so angeordnet sein, dass der/die Steg(e) oder zumindest ein Teil mindestens eines Steges bevorzugt bei entsprechender Ausrichtung auf der Höhe des/der Vorderkontakts/Vorderkontakte einer weiteren benachbarten Solarzelle angeordnet sein kann/können beziehungsweise bevorzugt auf dem/den Vorderkontakt(en) einer weiteren benachbarten Solarzelle ruhen kann/können und diese(n) gegebenenfalls zumindest teilweise berühren kann/können, sodass gegebenenfalls bereits durch Berührung mit dem Vorderkontakt eine elektrische Verbindung zwischen dem Verbindungsteil, des Verbindungselements, welches bevorzugt zum Beispiel über das Basisteil mit der Rückseite einer Solarzelle verbunden beziehungsweise verklebt ist, und dem Vorderkontakt einer weiteren benachbarten Solarzelle hergestellt werden kann. Alternativ dazu kann das Verbindungselement beziehungsweise das Verbindungsteil des Verbindungselements insbesondere bei einer planen Gestaltung des Verbindungselements zum Verbinden mit einem geeigneten Vorderkontakt einer benachbarten Solarzelle auch leicht gebogen/verbogen werden, um den Höhenunterschied zwischen der Rückseite der Solarzelle, welche mit dem Verbindungselement und insbesondere dem Basisteil des Verbindungselements verbunden beziehungsweise verklebt ist, und dem Vorderkontakt einer benachbarten Solarzelle, welcher nicht in der gleichen Ebene liegt ,zu überwinden, sodass das Verbindungsteil des Verbindungselements, welches bevorzugt zumindest teilweise auf der Höhe mindestens eines geeigneten Vorderkontakts einer weiteren benachbarten Solarzelle angeordnet werden kann, gegebenenfalls nach dem Biegen/Verbiegen bevorzugt zumindest teilweise auf mindestens einem geeigneten Vorderkontakt einer weiteren benachbarten Solarzelle ruhen kann und dass dadurch bevorzugt eine elektrische Verbindung zwischen den Verbindungsteil des Verbindungselements und dem geeigneten Vorderkontakt bequem hergestellt werden kann. Insbesondere können bevorzugt zum Beispiel 1 bis 8, weiter bevorzugt 1, 2 oder 4 Steg(e) vorgesehen sein, welche(r) gegebenenfalls mindestens zwei Streifen des Verbindungsteils des Verbindungselements miteinander verbindet/verbinden können, wobei die Gestaltung des Verbindungselements und insbesondere zum Beispiel die Länge und/oder Breite der Streifen, deren Abstand und/oder der Abstand zwischen den Stegen oder deren Länge und/oder Breite und/oder der Verlauf der Streifen, die mindestens zwei Segmente umfassen, beziehungsweise der Verlauf und/oder die Ausrichtung der entsprechenden Segmente oder Stege so gewählt werden kann, dass zum Beispiel mindestens ein Steg oder mindestens ein Teil davon zumindest teilweise bevorzugt bei entsprechender Ausrichtung des Verbindungselements und der damit verbundenen beziehungsweise verklebten Solarzelle bevorzugt auf einem Vorderkontakt einer Solarzelle, weiter bevorzugt auf einem Vorderkontakt insbesondere einem H-Bar-Vorderkontakt einer H-Bar-Solarzelle und insbesondere einer H-Bar-Siliziumsolarzelle, ruhen kann beziehungsweise auf der Höhe des entsprechenden Vorderkontakts angeordnet sein kann und diesen gegebenenfalls zumindest teilweise berühren kann, sodass gegebenenfalls bereits durch Berührung mit dem Vorderkontakt eine elektrische Verbindung zwischen dem Verbindungsteil des Verbindungselements, welches bevorzugt zum Beispiel über das Basisteil mit der Rückseite einer Solarzelle verbunden beziehungsweise verklebt ist, und dem Vorderkontakt einer weiteren benachbarten Solarzelle hergestellt werden kann. Des Weiteren kann durch diese bevorzugte Gestaltung des Verbindungselements und insbesondere des Verbindungsteils des Verbindungselements die Rückseite einer Solarzelle, welche mit dem Verbindungselement verbunden beziehungsweise verklebt ist, gegebenenfalls mit mindestens einem Vorderkontakt einer weiteren benachbarten Solarzelle elektrisch leitend verbunden oder verschaltet werden, ohne die Vorderseite der Solarzellen, die gegebenenfalls einfallendem Licht zugewendet sind, stark zu verdecken. Somit wird Stromproduktion der Solarzellen durch die Verschaltung möglichst wenig beeinflusst beziehungsweise beeinträchtigt. Zudem kann durch mindestens einen Steg oder bevorzugt durch mindesten zwei Stege, welche die Streifen des Verbindungsteils des Verbindungselements miteinander verbinden, eine bessere Formstabilität des Verbindungselements erreicht werden.

Dabei können die über mindestens einen bevorzugt mindestens zwei Steg(e) verbundenen Streifen des Verbindungsteils eines Verbindungselements, das mit der Rückseite einer Solarzelle verbunden beziehungsweise verklebt ist, gegebenenfalls zusammen mit dem Steg/den Stegen eine Art Rahmen bilden, der bevorzugt bei entsprechender Ausrichtung über eine benachbarte Solarzelle gelegt werden kann, wobei mindestens ein Teil dieses Rahmens beziehungsweise mindestens ein Streifen und/oder mindestens ein Steg des Verbindungsteils des Verbindungselements bevorzugt zumindest teilweise auf mindestens einem Vorderkontakt dieser benachbarten Solarzelle ruhen kann beziehungsweise zumindest teilweise auf der Höhe mindestens eines Vorderkontakts dieser benachbarten Solarzelle angeordnet sein kann und mindestens einen Vorderkontakt dieser benachbarten Solarzelle somit gegebenenfalls mindestens teilweise berühren kann, sodass gegebenenfalls bereits durch Berührung mit dem Vorderkontakt eine elektrische Verbindung zwischen dem Verbindungsteil des Verbindungselements, welches bevorzugt zum Beispiel über das Basisteil mit der Rückseite einer Solarzelle verbunden beziehungsweise verklebt ist, und dem Vorderkontakt einer weiteren benachbarten Solarzelle hergestellt werden kann. Dadurch kann eine besonders bequeme Verschaltung der benachbarten Solarzellen durch eine einfache elektrisch leitende Verbindung des Verbindungsteils des Verbindungelements, welches gegebenenfalls bereits mit der Rückseite einer Solarzelle verbunden beziehungsweise verklebt ist, und mindestens einem Vorderkontakt einer weiteren benachbarten Solarzelle ermöglicht werden, da das Verbindungsteil bevorzugt bereits zumindest teilweise auf mindestens einem Vorderkontakt einer benachbarten Solarzelle ruhen kann beziehungsweise zumindest teilweise auf der Höhe mindestens eines Vorderkontakts einer benachbarten Solarzelle angeordnet sein kann und diesen gegebenenfalls zumindest teilweise berühren kann, sodass über die elektrische Verbindung durch Berührung hinaus gegebenenfalls eine zusätzliche elektrische Verbindung zwischen einer Solarzelle, welche gegebenenfalls bereits mit der Rückseite einer Solarzelle verbunden beziehungsweise verklebt ist, und mindestens einem Vorderkontakt einer weiteren benachbarten Solarzelle zum Beispiel durch Löten, Laserlöten, Ultraschalllöten, Schweißen oder elektrisch leitendes Kleben sehr bequem und/oder gegebenenfalls insbesondere nach dem Platzieren der Solarzellen und/oder der Verbindungselemente und/oder der Verbünde aus einer Solarzelle und einem Verbindungselement ohne weitere Manipulation der Solarzellen und/oder der Verbindungselemente und/oder der Verbünde aus einer Solarzelle und einem Verbindungselement hergestellt werden kann. Durch Verbindungselemente, welche formstabiler sind, kann das Risiko einer Verformung und Beschädigung der Gestaltung der Verbindungselemente durch einen zum Herstellen eines Solarmoduls erforderlichen Arbeitsschritt, zum Beispiel einen Manipulations-, Greif-, Klebe-, Platzier-, Löt- und Transportschritt, reduziert werden.

In einer bevorzugten Ausführungsform der vorliegenden Erfindung kann das elektrisch leitende Verbindungselement, welches gegebenenfalls bereits mit der Rückseite einer Solarzelle verbunden beziehungsweise verklebt ist, und dabei insbesondere das Verbindungsteil des Verbindungselements, welches bevorzugt gegebenenfalls bei entsprechender Ausrichtung zumindest teilweise auf mindestens einem Vorderkontakt einer weiteren benachbarten Solarzelle ruhen beziehungsweise zumindest teilweise auf der Höhe mindestens eines Vorderkontakts einer weiteren benachbarten Solarzelle angeordnet sein und diesen gegebenenfalls zumindest teilweise berühren, sodass gegebenenfalls bereits durch Berührung mit dem Vorderkontakt eine elektrische Verbindung zwischen dem Verbindungsteil, des Verbindungselements, welches bevorzugt zum Beispiel über das Basisteil mit der Rückseite einer Solarzelle verbunden beziehungsweise verklebt ist, und dem Vorderkontakt einer weiteren benachbarten Solarzelle hergestellt werden kann. Eine elektrische Verbindung zwischen Verbindungsteil eines Verbindungselements, welches gegebenenfalls bereits mit der Rückseite einer Solarzelle verbunden beziehungsweise verklebt sein kann, und mindestens einem Vorderkontakt einer benachbarten Solarzelle, auf dem das Verbindungsteil zumindest teilweise bereits ruhen kann beziehungsweise auf dessen Höhe das Verbindungsteil zumindest teilweise bereits angeordnet sein kann, sodass das Verbindungsteil diesen Vorderkontakt (insbesondere bei einer planen Gestaltung des Verbindungselements gegebenenfalls nach dem Biegen/Verbiegen) bevorzugt zumindest teilweise berühren kann, kann über die elektrische Verbindung durch Berührung hinaus gegebenenfalls auch durch eine zusätzliche elektrische Verbindung, die zum Beispiel durch Löten, Laserlöten, Ultraschalllöten, Schweißen oder elektrisch leitend Kleben hergestellt werden kann, gegebenenfalls dauerhafter gestaltet werden. Das Verbindungsteil des elektrisch leitenden Verbindungselements, welches mit einer Rückseite einer Solarzelle verbunden ist, kann dabei gegebenenfalls zum Beispiel durch Löten, Laserlöten, Ultraschalllöten, Schweißen oder elektrisch leitend Kleben mit mindesten einem geeigneten Vorderkontakt einer benachbarter Solarzelle elektrisch leitend verbunden werden. Dadurch kann die Verschaltung von jeweils benachbarten Solarzellen mit dem erfindungsgemäßen Verfahren besonders bequem und dauerhaft ermöglicht werden, indem eine elektrisch leitende Verbindung des Verbindungsteils des Verbindungelements, welches gegebenenfalls bereits mit der Rückseite einer Solarzelle verbunden beziehungsweise verklebt sein kann, und mindestens einem Vorderkontakt einer weiteren benachbarten Solarzelle gegebenenfalls besonders einfach ermöglicht werden kann, da das Verbindungsteil bereits zumindest teilweise auf der Höhe mindestens eines Vorderkontakts einer benachbarten Solarzelle angeordnet sein kann beziehungsweise bevorzugt (insbesondere bei einer planen Gestaltung des Verbindungselements gegebenenfalls nach dem Biegen/Verbiegen) zumindest teilweise auf mindestens einem Vorderkontakt einer benachbarten Solarzelle ruhen kann und diesen gegebenenfalls zumindest teilweise berühren kann, sodass über die elektrische Verbindung durch Berührung hinaus gegebenenfalls eine zusätzliche elektrische Verbindung zwischen einer Solarzelle, welche gegebenenfalls bereits mit der Rückseite einer Solarzelle verbunden beziehungsweise verklebt ist, und mindestens einem Vorderkontakt einer weiteren benachbarten Solarzelle zum Beispiel durch Löten, Laserlöten, Ultraschalllöten, Schweißen oder elektrisch leitendes Kleben sehr bequem und/oder gegebenenfalls insbesondere nach dem Platzieren der Solarzellen und/oder der Verbindungselemente und/oder der Verbünde aus einer Solarzelle und einem Verbindungselement nach dem Platzieren der Solarzellen und/oder der Verbindungselemente und/oder der Verbünde aus einer Solarzelle und einem Verbindungselement ohne weitere Manipulation des Solarzellen und/oder der Verbindungselemente und/oder der Verbünde aus einer Solarzelle und einem Verbindungselement hergestellt werden kann.

Dabei kann die Ausrichtung der Verbindungselemente und insbesondere der Verbindungsteile der Verbindungselemente beziehungsweise der Verbünde aus jeweils einer Solarzelle und einem Verbindungselement vor/bei der Platzierung der Solarzellen, welche jeweils mit einem Verbindungselement verbunden beziehungsweise verklebt sind, beziehungsweise vor/bei der Platzierung der Verbünde aus jeweils einer Solarzelle und einem Verbindungselement bevorzugt zum Beispiel entsprechend so gewählt werden, dass zumindest ein Teil des Verbindungsteils des Verbindungselements, welches mit der Rückseite einer Solarzelle verbunden beziehungsweise verklebt sind, zumindest teilweise auf der Höhe eines geeigneten Vorderkontakts einer weiteren benachbarten Solarzelle, angeordnet werden und/oder insbesondere zum Beispiel auf einem geeigneten Vorderkontakt, einer weiteren benachbarten Solarzellen ruhen kann, sodass die Herstellung einer elektrisch leitendenes Verbindung erfindungsgemäß besonders schnell und bequem, zum Beispiel durch Löten, Laserlöten, Ultraschalllöten, Schweißen oder elektrisch leitend Kleben eines Teils des Verbindungselements, welches mit der Rückseite einer Solarzelle bereits verbunden beziehungsweise verklebt ist und dessen Verbindungsteil (insbesondere bei einer planen Gestaltung des Verbindungselements gegebenenfalls nach dem Biegen/Verbiegen) bevorzugt auf einem geeigneten Vorderkontakt zu einer weiteren benachbarten Solarzelle ruhen kann, mit diesem geeigneten Vorderkontakt einer weiteren benachbarten Solarzelle erfolgen kann, da ein Teil des Verbindungselements bevorzugt bei entsprechender Ausrichtung bereits gegebenenfalls (insbesondere bei einer planen Gestaltung des Verbindungselements gegebenenfalls nach dem Biegen/Verbiegen) auf einem geeigneten Vorderkontakt einer weiteren benachbarten Solarzellen ruhen kann. Die Ausrichtung kann dabei zum Beispiel insbesondere über die Richtung variiert werden in der das Verbindungsteil des Verbindungselements vor/beim Platzieren zeigt beziehungsweise vor/beim Platzieren gedreht beziehungsweise gelegt wird. Das Verbindungsteil des Verbindungselements kann dabei zum Beispiel bevorzugt nach oben, nach unten, nach rechts oder nach links zeigen beziehungsweise gedreht beziehungsweise gelegt werden. Die Ausrichtung der Solarzellen, welche jeweils mit einem Verbindungselement verbunden beziehungsweise verklebt sind, beziehungsweise der Verbünde aus jeweils einer Solarzelle und einem Verbindungselement kann dabei bevorzugt zum Beispiel durch eine oder mehrere Drehbewegung(en) verändert werden.

Die Platzierung und/oder die Ausrichtung der Solarzellen und/oder der damit gegebenenfalls verbundenen beziehungsweise verklebten Verbindungselemente und/oder der Verbünde aus je einer Solarzelle und je einem Verbindungselement während der Herstellung eines Solarmodul insbesondere zum Beispiel innerhalb des Solarzellstrings, des Solarmoduls, des Rahmens des Solarmoduls, des Aufbaus des Solarmoduls oder auf einer Rückplatte des Solarmoduls, kann bei dem erfindungsgemäßen Verfahren zumindest teilweise bevorzugt jedoch größtenteils automatisch zum Beispiel durch geeignete Maschinen oder Roboter, bevorzugt zum Beispiel mit ein sogenanntes "Pick and place"-Verfahren, erfolgen. Das erfindungsgemäße Verfahren kann es dabei erlauben, insbesondere die Platzierung und/oder die Ausrichtung der Solarzellen und der damit gegebenenfalls verbundenen beziehungsweise verklebten Verbindungselemente und/oder der Verbünde aus je einer Solarzelle und je einem Verbindungselement während der Herstellung eines Solarmoduls insbesondere zum Beispiel innerhalb des Solarmoduls, des Rahmens des Solarmoduls, des Aufbaus des Solarmoduls oder auf einer Rückplatte des Solarmoduls, im erfindungsgemäßen Verfahren bevorzugt auch dann größtenteils automatisch zum Beispiel durch geeignete Maschinen oder Roboter, bevorzugt zum Beispiel mit dem "Pick and place"-Verfahren, zu ermöglichen, wenn Solarzellen mit mindestens einem Vorderkontakt, insbesondere einem H-Bar-Vorderkontakt beziehungsweise H-Bar-Siliziumsolarzellen, verwendet werden. Dadurch lassen sich die Verschaltung von Solarzellen zur Herstellung von Solarmodulen und somit auch die Herstellung von Solarmodulen erheblich vereinfachen, insbesondere auch wenn zum Beispiel Solarzellen mit mindestens einem Vorderkontakt, insbesondere einem H-Bar-Vorderkontakt beziehungsweise H-Bar-Siliziumsolarzellen, verwendet werden. Dadurch lassen sich insbesondere die gegebenenfalls erforderlichen Manipulationsschritte zur Herstellung eines Moduls reduzieren.

In einer besonderen Ausführungsform kann die Rückseite des Verbindungselements, welche also nicht mit der Rückseite einer Solarzelle verklebt ist/wird und gegebenenfalls auf der von der Sonneneinstrahlung abgewendeten Seite liegen kann, einen gegebenenfalls dekorativen Aufdruck aufweisen, der ein beliebiges Muster oder Logo umfassen kann. Der dekorative Aufdruck kann dabei in einer beliebigen Farbe und/oder mit eine beliebigen Farbkombination zum Beispiel insbesondere durch ein Siebdruckverfahren aufgebracht werden.

Besondere Ausführungsformen eines Verbindungselements werden nachfolgend anhand der Zeichnungen dargestellt und beschrieben.

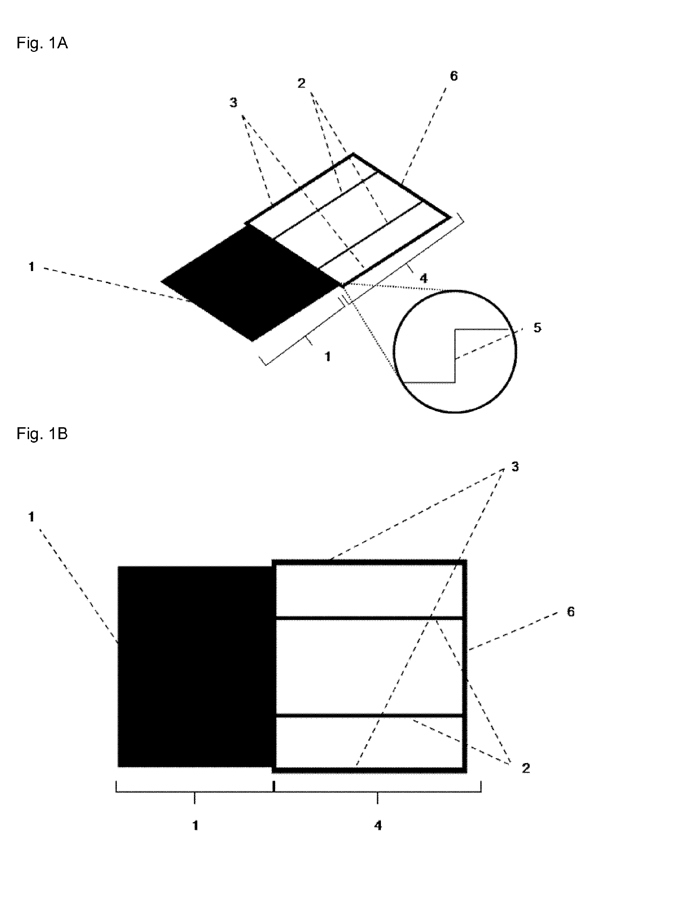

Die Figuren 1A (Ansicht schräg von oben) und 1 B (Draufsicht) stellen zwei Ansichten einer bevorzugten Ausführungsform eines elektrisch leitenden

Verbindungselementes dar, wobei das Verbindungselement ein quadratisches Basisteil (1) umfasst, welches mit der Rückseite der ersten Solarzelle elektrisch leitend verbunden beziehungsweise verklebt werden kann und bevorzugt der Form der Rückseite der Solarzelle entspricht, sodass die Rückseite der Solarzelle zum Beispiel weitgehend oder nahezu komplett beziehungsweise bevorzugt komplett vom Verbindungselement beziehungsweise vom Basisteil des Verbindungselements bedeckt und gegebenenfalls unterstützt werden kann, wobei zudem zwei auf Abstand angeordnete rechteckige Streifen (2) sowie zwei Streifen (3), die mehrere beziehungsweise mindestens zwei Segmente umfassen, als Verbindungsteil (4) vorgesehen sind. Die Streifen (2,3) erstrecken sich dabei über das Basisteil (1) des Verbindungselements, welches mit der Rückseite einer Solarzelle verbunden beziehungsweise verklebt werden kann, hinaus, sodass zumindest ein Teil jedes rechteckigen Streifens (2) bevorzugt bei entsprechender Ausrichtung, bevorzugt zum Beispiel zumindest teilweise auf der Höhe eines geeigneten Vorderkontakts einer weiteren benachbarten Solarzelle, angeordnet sein und/oder dabei insbesondere zum Beispiel auf mindestens einem Vorderkontakt einer weiteren benachbarten Solarzelle ruhen kann. Dabei ist das Verbindungselement, welches mit der Rückseite einer Solarzelle verbunden beziehungsweise verklebt wird, so gestaltet beziehungsweise so in Form gebracht, dass es eine nicht plane Gestaltung aufweist, wobei bevorzugt ein Knick beziehungsweise eine Stufe (5) (siehe Ausschnitt der Seitenansicht des Verbindungselements) am Übergang zwischen dem Basisteil und dem Verbindungsteil vorgesehen ist, sodass zumindest ein Teil jedes Streifens (2,3) des Verbindungsteils (4) des Verbindungselements, welches mit der Rückseite einer Solarzelle verbunden beziehungsweise verklebt werden kann, bei entsprechender Ausrichtung bevorzugt auf mindestens einem Vorderkontakt einer weiteren benachbarten Solarzelle ruhen kann , auch wenn die Rückseite der Solarzelle, welche mit dem Basisteil (1) des Verbindungselements verbunden beziehungsweise verklebt sein kann, beim verwendeten Solarzelltyp gegebenenfalls nicht in einer Ebene mit dem Vorderkontakt einer weiteren benachbarten Solarzelle liegt.

Dabei kann die Gestaltung des Verbindungselements und insbesondere zum Beispiel die Länge und Breite der Streifen oder deren Abstand, so gewählt werden, dass zumindest ein Teil der rechteckigen Streifen (2) bei entsprechender Ausrichtung des Verbindungselements und der damit gegebenenfalls verbundenen beziehungsweise verklebten Solarzelle, bevorzugt zumindest teilweise auf mindestens einem Vorderkontakt einer weiteren benachbarten Solarzelle, bevorzugt auf einem Vorderkontakt insbesondere einem H-Bar-Vorderkontakt einer H-Bar-Solarzelle und insbesondere einer H-Bar-Siliziumsolarzelle, ruhen und diesen gegebenenfalls zumindest teilweise berühren kann. Dadurch wird eine besonders bequeme Verschaltung von benachbarten Solarzellen ermöglicht.

Bevorzugt können die Verbindungselemente und die damit gegebenenfalls verbundenen beziehungsweise verklebten Solarzellen und/oder die Verbünde aus je einer Solarzelle und je einem Verbindungselement so ausgerichtet und/oder platziert werden, dass die rechteckigen Streifen (2) des Verbindungsteils des Verbindungselements jeweils auf den Vorderkontakten insbesondere den H-Bar-Vorderkontakten einer H-Bar-Solarzelle und insbesondere einer H-Bar-Siliziumsolarzelle gelegt werden und auf diesen ruhen können, wobei sie diese somit zumindest teilweise berühren können.

Zudem sind die auf Abstand angeordneten Streifen (2,3) über einen Steg (6), miteinander verbunden. Der Steg (6) ist dabei quer und rechtwinklig zu den Streifen beziehungsweise zu mindestens einem Segment eines Streifens des Verbindungsteils (4) des Verbindungselementes angeordnet.

Durch den Steg (6), der die Streifen (2,3) des Verbindungsteils (4) des Verbindungselements miteinander verbindet, kann eine bessere Formstabilität des Verbindungselements erreicht werden.

Dabei bilden die über mindestens einen Steg (6) verbundenen Streifen (2,3) des Verbindungsteils (4) eines Verbindungselements, das mit der Rückseite einer Solarzelle verbunden beziehungsweise verklebt kann, zusammen mit dem Steg eine Art Rahmen, der über eine benachbarte Solarzelle gelegt werden kann, wobei mindestens ein Vorderkontakt dieser benachbarten Solarzelle mindestens teilweise durch mindestens einen Streifen (2) des Verbindungsteils (4) des Verbindungselements zumindest teilweise berührt werden kann, um eine einfache Verschaltung der benachbarten Solarzellen zu ermöglichen. Durch die Bildung eines Rahmens kann dabei ebenfalls eine bessere Formstabilität des Verbindungselements erreicht werden. Verbindungselemente, die formstabiler sind, können das Risiko einer Verformung und Beschädigung der Gestaltung der Verbindungselemente durch einen zum Herstellen eines Solarmoduls erforderlichen Arbeitsschritt, zum Beispiel einen Manipulations-, Greif-, Klebe-, Platzier-, Löt- und Transportschritt, reduzieren.

Durch Gestaltung des Verbindungselements und insbesondere des Verbindungsteils (4) des Verbindungselements kann die Rückseite einer Solarzelle, welche mit dem Basisteil (1) des Verbindungselement verbunden beziehungsweise verklebt ist, gegebenenfalls mit mindestens eine, Vorderkontakt einer weiteren benachbarten Solarzelle elektrisch leitenden verbunden oder verschaltet werden, ohne die Vorderseite der Solarzellen, die gegebenenfalls einfallendem Licht zugewendet sind, stark zu verdecken. Somit wird Stromproduktion der Solarzellen durch die Verschaltung möglichst wenig beeinflusst beziehungsweise beeinträchtigt.

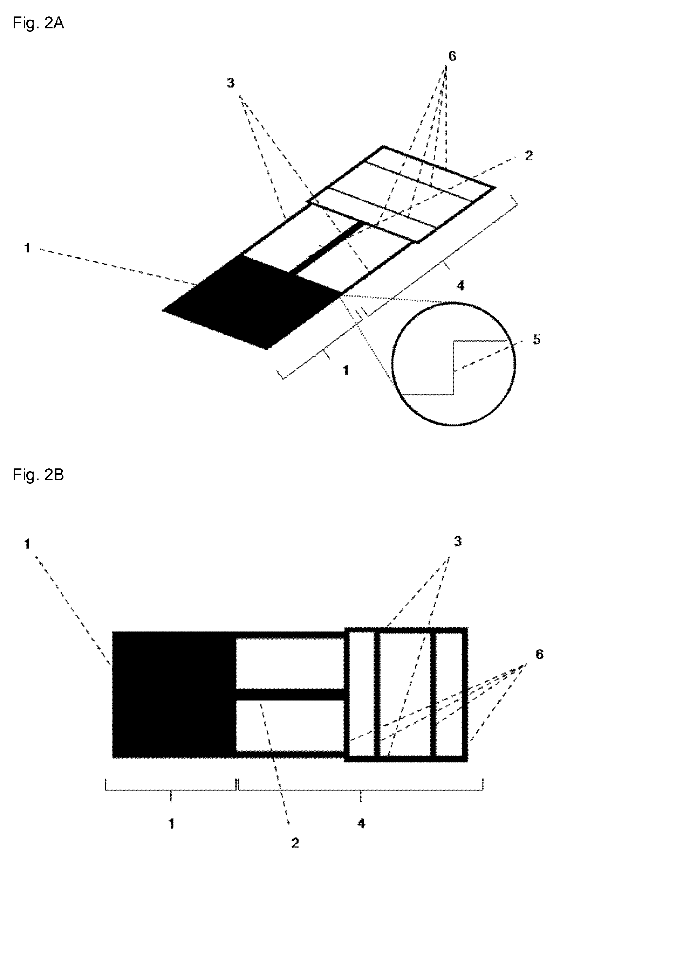

Die Figuren 2A (Ansicht schräg von oben) und 2B (Draufsicht) stellen zwei Ansichten einer bevorzugten Ausführungsform eines elektrisch leitende Verbindungselementes dar, wobei das Verbindungselement ein quadratisches Basisteil (1) umfasst, welches mit der Rückseite der ersten Solarzelle elektrisch leitend verbunden beziehungsweise verklebt werden kann und bevorzugt der Form der Rückseite der Solarzelle entspricht, sodass die Rückseite der Solarzelle zum Beispiel weitgehend oder nahezu komplett beziehungsweise bevorzugt komplett vom Verbindungselement beziehungsweise vom Basisteil des Verbindungselements bedeckt und gegebenenfalls unterstützt werden kann, wobei zudem ein mittig angeordneter rechteckiger Streifen (2) sowie zwei Streifen (3), die mehrere beziehungsweise mindestens zwei Segmente umfassen, als Verbindungsteil (4) vorgesehen sind. Die Streifen (2,3) erstrecken sich dabei über das Basisteil (1) des Verbindungselements, welches mit der Rückseite einer Solarzelle verbunden beziehungsweise verklebt werden kann, hinaus, sodass zumindest ein Teil des Verbindungteils des Verbindungselementes bevorzugt bei entsprechender Ausrichtung, bevorzugt zum Beispiel zumindest teilweise auf der Höhe eines geeigneten Vorderkontakts einer weiteren benachbarten Solarzelle, angeordnet sein und/oder dabei insbesondere zum Beispiel auf mindestens einem Vorderkontakt einer weiteren benachbarten Solarzelle ruhen kann. Dabei ist das Verbindungselement, welches mit der Rückseite einer Solarzelle verbunden beziehungsweise verklebt wird, so gestaltet beziehungsweise so in Form gebracht, dass es eine nicht plane Gestaltung aufweist, wobei bevorzugt ein Knick beziehungsweise eine Stufe (5) (siehe Ausschnitt der Seitenansicht des Verbindungselements) am Übergang zwischen dem Basisteil und dem Verbindungsteil vorgesehen ist, sodass zumindest ein Teil des Verbindungsteils (4) des Verbindungselements, welches mit der Rückseite einer Solarzelle verbunden beziehungsweise verklebt werden kann, bei entsprechender Ausrichtung bevorzugt auf mindestens einem Vorderkontakt einer weiteren benachbarten Solarzelle ruhen kann, auch wenn die Rückseite der Solarzelle, welche mit dem Basisteil (1) des Verbindungselements verbunden beziehungsweise verklebt sein kann, beim verwendeten Solarzelltyp gegebenenfalls nicht in einer Ebene mit dem Vorderkontakt einer weiteren benachbarten Solarzelle liegt.

Zudem sind die auf Abstand angeordneten Streifen (2,3) über vier Stege (6), miteinander verbunden. Die Stege (6) sind dabei quer und rechtwinklig zu den Streifen beziehungsweise zu mindestens einem Segment eines Streifens des Verbindungsteils (4) des Verbindungselementes angeordnet. Dabei sind die drei Streifen (2,3) über einen Steg (6) miteinander verbunden. Die zwei Streifen (3), die mehrere beziehungsweise mindestens zwei Segmente umfassen, sind darüber hinaus noch über drei Stege (6) miteinander verbunden.

Durch die Stege (6), die die Streifen (2,3) des Verbindungsteils (4) des Verbindungselements miteinander verbinden, kann eine bessere Formstabilität des Verbindungselements erreicht werden.

Dabei kann die Gestaltung des Verbindungselements und insbesondere zum Beispiel die Länge und Breite der Streifen oder deren Abstand, so gewählt werden, dass zumindest ein Teil der Stege (6) und insbesondere der beiden mittleren Stege (6) bei entsprechender Ausrichtung des Verbindungselements und der damit gegebenenfalls verbundenen beziehungsweise verklebten Solarzelle, bevorzugt auf einem Vorderkontakt einer weiteren benachbarten Solarzelle, bevorzugt zumindest teilweise auf mindestens einem Vorderkontakt insbesondere einem H-Bar-Vorderkontakt einer H-Bar-Solarzelle und insbesondere einer H-Bar-Siliziumsolarzelle, ruhen und diesen gegebenenfalls zumindest teilweise berühren kann. Dadurch wird eine besonders bequeme Verschaltung von benachbarten Solarzellen ermöglicht.

Bevorzugt können die Verbindungselemente und die damit gegebenenfalls verbundenen beziehungsweise verklebten Solarzellen und/oder die Verbünde aus je einer Solarzelle und je einem Verbindungselement so ausgerichtet und/oder platziert werden, dass die Stege (6) und insbesondere die beiden mittleren Stege (6) des Verbindungsteils des Verbindungselements jeweils auf die Vorderkontakte insbesondere die H-Bar-Vorderkontakte einer H-Bar-Solarzelle und insbesondere einer H-Bar-Siliziumsolarzelle gelegt werden und auf diesen ruhen können, wobei sie diese somit zumindest teilweise berühren können.

Der rechteckige Streifen (2) kann dabei breiter vorgesehen sein, um den elektrischen Widerstand zu reduzieren. Der Streifen (2) trägt dabei zudem zu einer größeren Formstabilität des Verbindungsteils des Verbindungselements bei. Eine hohe Formstabilität kann dabei insbesondere erwünscht sein, wenn ein größerer Abstand beziehungsweise wenn eine größere Distanz zwischen benachbarten Solarzellen überbrückt werden soll. Die Länge der Streifen (2,3) wird dabei so gewählt, dass ein größerer Abstand beziehungsweise eine größere Distanz zwischen benachbarten Solarzellen überbrückt werden kann. Der zu überbrückende Abstand kann dabei der Länge des rechteckigen Streifens (2) entsprechen. Der Teil des Verbindungsteils (4), der der Länge des rechteckigen Streifens (2) entspricht, kann dabei insbesondere dazu dienen, einen größeren Anstand beziehungsweise eine größere Distanz zwischen benachbarten Solarzellen zu überbrücken.

Dabei bilden die über die Stege (6) verbundenen Streifen (3) des Verbindungsteils (4) eines Verbindungselements, das mit der Rückseite einer Solarzelle verbunden beziehungsweise verklebt werden kann, zusammen mit den zwei äußeren Stegen (6) eine Art Rahmen, der über eine benachbarte Solarzelle gelegt werden kann, wobei mindestens ein Vorderkontakt dieser benachbarten Solarzelle mindestens teilweise durch mindestens einen bevorzugt einen der beiden mittleren Stege (6) des Verbindungsteils (4) des Verbindungselements zumindest teilweise berührt werden kann, um eine einfache Verschaltung der benachbarten Solarzellen zu ermöglichen. Durch die Bildung eines Rahmens kann dabei ebenfalls eine bessere Formstabilität des Verbindungselements erreicht werden. Verbindungselemente, die formstabiler sind, können das Risiko einer Verformung und Beschädigung der Gestaltung der Verbindungselemente durch einen zum Herstellen eines Solarmoduls erforderlichen Arbeitsschritt, zum Beispiel einen Manipulations-, Greif-, Klebe-, Platzier-, Löt- und Transportschritt, reduzieren.

Durch Gestaltung des Verbindungselements und insbesondere des Verbindungsteils (4) des Verbindungselements kann die Rückseite einer Solarzelle, welche mit dem Basisteil (1) des Verbindungselement verbunden beziehungsweise verklebt ist, gegebenenfalls mit mindestens einem Vorderkontakt einer weiteren benachbarten Solarzelle elektrisch leitend verbunden oder verschaltet werden, ohne die Vorderseite der Solarzellen, die gegebenenfalls einfallendem Licht zugewendet sind, stark zu verdecken. Somit wird Stromproduktion der Solarzellen durch die Verschaltung möglichst wenig beeinflusst beziehungsweise beeinträchtigt.

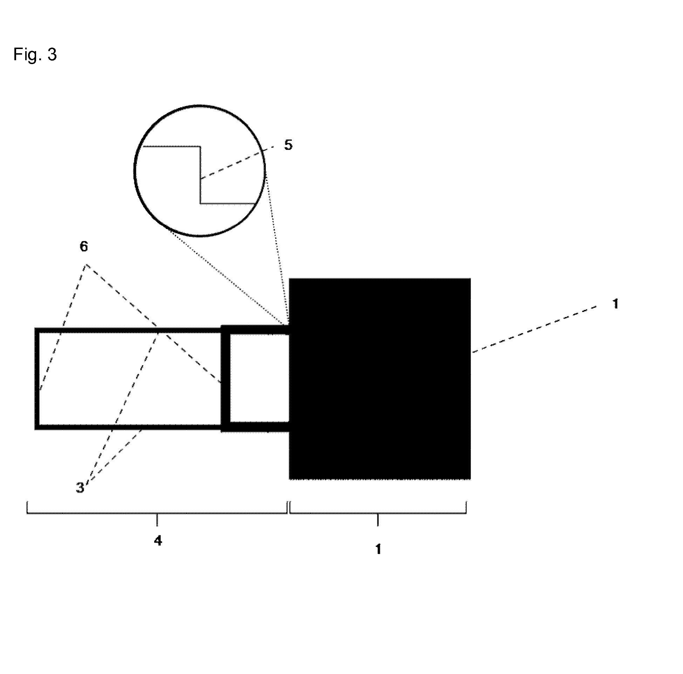

Die Figur 3 (Draufsicht) stellt eine bevorzugte Ausführungsform eines elektrisch leitenden Verbindungselementes dar, wobei das Verbindungselement ein quadratisches Basisteil (1) umfasst, welches mit der Rückseite der ersten Solarzelle elektrisch leitend verbunden beziehungsweise verklebt werden kann und bevorzugt der Form der Rückseite der Solarzelle entspricht, sodass die Rückseite der Solarzelle zum Beispiel weitgehend oder nahezu komplett beziehungsweise bevorzugt komplett vom Verbindungselement beziehungsweise vom Basisteil des Verbindungselements bedeckt und gegebenenfalls unterstützt werden kann, wobei zudem zwei Streifen (3), die mehrere beziehungsweise mindestens zwei Segmente umfassen, als Verbindungsteil (4) vorgesehen sind. Die Streifen (3) erstrecken sich dabei über das Basisteil (1) des Verbindungselements, welches mit der Rückseite einer Solarzelle verbunden beziehungsweise verklebt werden kann, hinaus, sodass zumindest ein Teil jedes Streifens (3) bevorzugt bei entsprechender Ausrichtung, bevorzugt zum Beispiel zumindest teilweise auf der Höhe eines geeigneten Vorderkontakts einer weiteren benachbarten Solarzelle, angeordnet sein und/oder dabei insbesondere zum Beispiel auf mindestens einem Vorderkontakt einer weiteren benachbarten Solarzelle ruhen kann. Dabei ist das Verbindungselement, welches mit der Rückseite einer Solarzelle verbunden beziehungsweise verklebt wird, so gestaltet beziehungsweise so in Form gebracht, dass es eine nicht plane Gestaltung aufweist, wobei bevorzugt ein Knick beziehungsweise eine Stufe (5) (siehe Ausschnitt der Seitenansicht des Verbindungselements) am Übergang zwischen dem Basisteil und dem Verbindungsteil vorgesehen ist, sodass zumindest ein Teil jedes Streifens (3) des Verbindungsteils (4) des Verbindungselements, welches mit der Rückseite einer Solarzelle verbunden beziehungsweise verklebt werden kann, bei entsprechender Ausrichtung auf mindestens einem Vorderkontakt einer weiteren benachbarten Solarzelle ruhen kann, auch wenn die Rückseite der Solarzelle, welche mit dem Basisteil (1) des Verbindungselements verbunden beziehungsweise verklebt sein kann, beim verwendeten Solarzelltyp gegebenenfalls nicht in einer Ebene mit dem Vorderkontakt einer weiteren benachbarten Solarzelle liegt.

Zudem sind die auf Abstand angeordneten Streifen (3) über zwei Stege (6), miteinander verbunden. Die Stege (6) sind dabei quer und rechtwinklig zu den Streifen beziehungsweise zu mindestens einem Segment eines Streifens des Verbindungsteils (4) des Verbindungselementes angeordnet. Die Breite der Stege (6) ist dabei unterschiedlich. Der Steg (6), der am nächsten zum Basisteil vorgesehen ist, ist dabei breiter, um den elektrischen Widerstand zu reduzieren.

Durch die Stege (6), die die Streifen (3) des Verbindungsteils (4) des Verbindungselements miteinander verbinden, kann eine bessere Formstabilität des Verbindungselements erreicht werden.

Dabei kann die Gestaltung des Verbindungselements und insbesondere zum Beispiel die Länge und Breite der Streifen oder deren Abstand, so gewählt werden, dass zumindest ein Teil jedes Streifens (3) bei entsprechender Ausrichtung des Verbindungselements und der damit gegebenenfalls verbundenen beziehungsweise verklebten Solarzelle, bevorzugt zumindest teilweise auf mindestens einem Vorderkontakt einer weiteren benachbarten Solarzelle, bevorzugt auf einem Vorderkontakt insbesondere einem H-Bar-Vorderkontakt einer H-Bar-Solarzelle und insbesondere einer H-Bar-Siliziumsolarzelle, ruhen und diesen gegebenenfalls zumindest teilweise berühren kann. Dadurch wird eine besonders bequeme Verschaltung von benachbarten Solarzellen ermöglicht.

Bevorzugt können die Verbindungselemente und die damit gegebenenfalls verbundenen beziehungsweise verklebten Solarzellen und/oder die Verbünde aus je einer Solarzelle und je einem Verbindungselement so ausgerichtet und/oder platziert werden, dass die Streifen (3) und insbesondere die beiden dünneren Segmente der Streifen (3) des Verbindungsteils des Verbindungselements jeweils auf die Vorderkontakte insbesondere die H-Bar-Vorderkontakte einer H-Bar-Solarzelle und insbesondere einer H-Bar-Siliziumsolarzelle gelegt werden und auf diesen ruhen können, wobei sie diese somit zumindest teilweise berühren können.

Das erste Segment jedes Streifens (3) kann dabei breiter vorgesehen sein, um den elektrischen Widerstand zu reduzieren. Eine hohe Formstabilität kann dabei insbesondere erwünscht sein, wenn ein Abstand beziehungsweise wenn eine Distanz zwischen benachbarten Solarzellen überbrückt werden soll. Die Länge des ersten Segments der Streifen (3) wird dabei so gewählt, dass ein Abstand beziehungsweise eine Distanz zwischen benachbarten Solarzellen überbrückt werden kann. Der zu überbrückende Abstand kann dabei der Länge des ersten Segmentes der Streifen (3) entsprechen. Der Teil des Verbindungsteils (4), der der Länge der ersten Segmente der Streifen (3) entspricht, kann dabei insbesondere dazu dienen, einen Anstand beziehungsweise eine Distanz zwischen benachbarten Solarzellen zu überbrücken.

Dabei bilden die über den dünneren Steg (6) verbundenen Streifen (3) des Verbindungsteils (4) eines Verbindungselements, das mit der Rückseite einer Solarzelle verbunden beziehungsweise verklebt werden kann, zusammen mit dem dünneren Steg (6) eine Art Rahmen, der über eine benachbarte Solarzelle gelegt werden kann, wobei mindestens ein Vorderkontakt dieser benachbarten Solarzelle mindestens teilweise durch mindestens einen bevorzugt Streifen (3) des Verbindungsteils (4) des Verbindungselements zumindest teilweise berührt werden kann, um eine einfache Verschaltung der benachbarten Solarzellen zu ermöglichen. Durch die Bildung eines Rahmens kann dabei ebenfalls eine bessere Formstabilität des Verbindungselements erreicht werden. Verbindungselemente, die formstabiler sind, können das Risiko einer Verformung und Beschädigung der Gestaltung der Verbindungselemente durch einen zum Herstellen eines Solarmoduls erforderlichen Arbeitsschritt, zum Beispiel einen Manipulations-, Greif-, Klebe-, Platzier-, Löt- und Transportschritt, reduzieren.

Durch Gestaltung des Verbindungselements und insbesondere des Verbindungsteils (4) des Verbindungselements kann die Rückseite einer Solarzelle, welche mit dem Basisteil (1) des Verbindungselement verbunden beziehungsweise verklebt ist, gegebenenfalls mit mindestens einem Vorderkontakt einer weiteren benachbarten Solarzelle elektrisch leitend verbunden oder verschaltet werden, ohne die Vorderseite der Solarzellen, die gegebenenfalls einfallendem Licht zugewendet sind, stark zu verdecken. Somit wird Stromproduktion der Solarzellen durch die Verschaltung möglichst wenig beeinflusst beziehungsweise beeinträchtigt.

### Bezugszeichenliste:

- 1: Basisteil
- 2: Rechteckiger Streifen des Verbindungsteils
- 3: Streifen des Verbindungteils, welcher mindestens zwei Segmente umfasst
- 4: Verbindungsteil
- 5: Knick beziehungsweise Stufe (in der Seitenansicht des Verbindungselements)
- 6: Steg des Verbindungsteils

## Patentansprüche

1. Verfahren zum Verbinden von Solarzellen,
**dadurch gekennzeichnet,**
**dass** ein elektrisch leitendes Verbindungselement mit der Rückseite einer Solarzelle elektrisch leitend verbunden wird, wobei diese Solarzelle neben einer benachbarten Solarzelle platziert wird, sodass sich zumindest ein Teil des Verbindungselements nach der Platzierung der beiden Solarzellen und/oder der entsprechenden Verbindungselemente und/oder der beiden Verbünde aus jeweils einer Solarzelle und jeweils einem damit verbunden Verbindungselement bereits zumindest teilweise auf Höhe mindestens eines geeigneten Vorderkontakts der weiteren benachbarten Solarzelle befindet und somit durch die Berührung mindestens eines Teil des Verbindungselements, welches mit der Rückseite einer Solarzelle verbunden ist, und mindestens eines geeigneten Vorderkontakts einer weiteren benachbarten Solarzelle eine elektrische Verbindung zwischen den benachbarten Solarzellen hergestellt wird, wobei ferner die Gestaltung des Verbindungselements es ermöglicht, durch ein Verbindungselement jeweils immer nur zwei benachbarte Solarzellen miteinander zu verschalten.

2. Verfahren zum Verbinden von Solarzellen nach Anspruch 1,
**dadurch gekennzeichnet,**
**dass** zur Verschaltung der Solarzellen jeweils Verbünde aus jeweils einer Solarzelle und jeweils einem Verbindungsteil transportiert und/oder gegriffen und/oder gedreht und/oder ausgerichtet und/oder platziert und/oder manipuliert werden.

3. Verfahren zum Verbinden von Solarzellen nach einem oder beiden der Ansprüche 1 oder 2,
**dadurch gekennzeichnet,**
**dass** das elektrisch leitende Verbindungselement zwischen 20 % und 100 % der Fläche der Rückseite einer Solarzelle bedeckt, dessen Rückseite mit dem Verbindungelement und insbesondere mit dem Basisteil des Verbindungselements verbunden wird.

4. Verfahren zum Verbinden von Solarzellen nach einem oder mehreren der vorangegangenen Ansprüche,
**dadurch gekennzeichnet,**
**dass** das elektrisch leitende Verbindungselement mit einem elektrisch leitenden Kleber mit der Rückseite einer Solarzelle verklebt wird.

5. Verfahren zum Verbinden von Solarzellen nach einem oder mehreren der vorangegangenen Ansprüche,
**dadurch gekennzeichnet,**
**dass** das elektrisch leitende Verbindungselement ein Basisteil, welches mit der Rückseite einer Solarzelle elektrisch leitend verklebt wird, und ein Verbindungsteil, welches sich über das Basisteil hinaus erstreckt, umfasst.

6. Verfahren zum Verbinden von Solarzellen nach einem oder mehreren der vorangegangenen Ansprüche,
**dadurch gekennzeichnet,**
**dass** das Verbindungsteil des Verbindungselements, welches sich über das Basisteil hinaus erstreckt, mindestens einen Streifen und/oder mindestens einen Steg, welcher sich über das Basisteil hinaus erstreckt, und/oder mindestens einen Steg umfasst.

7. Verfahren zum Verbinden von Solarzellen nach einem oder mehreren der vorangegangenen Ansprüche,
**dadurch gekennzeichnet,**
**dass** die Solarzellen, welche jeweils mit einem Verbindungselement verbunden sind, und/oder die Verbindungselemente und/oder die Verbünde aus jeweils einer Solarzelle und jeweils einem damit verbunden Verbindungselement vor/bei dem Platzieren der Solarzellen und/oder der Verbindungselemente und/oder der Verbünde aus jeweils einer Solarzelle und jeweils einem damit verbunden Verbindungselement jeweils so ausgerichtet werden, dass nach dem Platzieren mindestens ein Teil jedes Verbindungselements und insbesondere jedes Verbindungsteils zumindest teilweise auf mindestens einem geeigneten Vorderkontakt einer benachbarten Solarzelle ruht beziehungsweise zumindest teilweise auf der Höhe mindestens eines geeigneten Vorderkontakts einer benachbarten Solarzelle angeordnet ist.

8. Verfahren zum Verbinden von Solarzellen nach einem oder mehreren der vorangegangenen Ansprüche,
**dadurch gekennzeichnet,**
**dass** das Verbindungsteil des elektrisch leitenden Verbindungselements durch Löten, Laserlöten, Ultraschalllöten, Schweißen oder elektrisch leitendes Kleben mit mindesten einen geeigneten Vorderkontakt einer benachbarten Solarzelle elektrisch leitend verbunden wird.

9. Verbindungselement zum Verbinden von Solarzellen,
**dadurch gekennzeichnet,**
**dass** das elektrisch leitende Verbindungselement ein Basisteil umfasst, welches mit der Rückseite einer Solarzelle elektrisch leitend verbunden werden kann und zudem mindestens einen Streifen als Verbindungsteil umfasst, der sich über das Basisteil hinaus erstreckt, wobei das Verbindungselement eine Gestaltung aufweist, die es ermöglicht, dass mindestens ein Teil des Verbindungsteils bei entsprechender Ausrichtung zumindest teilweise auf mindestens einem Vorderkontakt einer weiteren benachbarten Solarzelle ruht beziehungsweise auf der Höhe mindestens eines Vorderkontakts einer weiteren benachbarten Solarzelle angeordnet ist.

10. Verbindungselement zum Verbinden von Solarzellen nach Anspruch 8,
**dadurch gekennzeichnet,**
**dass** das elektrisch leitende Verbindungselement ein rechteckiges oder quadratisches Basisteil umfasst, welches mit der Rückseite einer Solarzelle elektrisch leitend verbunden werden kann, und zudem mindestens zwei auf Abstand angeordnete Streifen als Verbindungsteil umfasst, die sich über das Basisteil hinaus erstrecken.

11. Verbindungselement zum Verbinden von Solarzellen nach einem oder mehreren der vorangegangenen Ansprüche,
**dadurch gekennzeichnet,**
**dass** das Verbindungselement eine plane oder eine nicht plane Gestaltung aufweist.

12. Verbindungselement zum Verbinden von Solarzellen nach einem oder mehreren der vorangegangenen Ansprüche,
**dadurch gekennzeichnet,**
**dass** das Verbindungselement eine Metallfolie oder eine Metallschicht und/oder eine Polymerfolie umfasst beziehungsweise dass das elektrisch leitende Verbindungselement aus einer Metallfolie besteht.

13. Verbindungselement zum Verbinden von Solarzellen nach einem oder mehreren der vorangegangenen Ansprüche,
**dadurch gekennzeichnet,**
**dass** das Verbindungsteil mindestens einen Steg umfasst und/oder dass mindestens zwei auf Abstand angeordnete Streifen des Verbindungsteils durch mindestens einen Steg verbunden sind.

14. Verbindungselement zum Verbinden von Solarzellen nach einem oder mehreren der vorangegangenen Ansprüche,
**dadurch gekennzeichnet,**
**dass** mindestens ein Streifen des Verbindungsteils rechteckig ist und/oder mindestens zwei Segmente umfasst.

15. Verbindungselement zum Verbinden von Solarzellen nach einem oder mehreren der vorangegangenen Ansprüche,
**dadurch gekennzeichnet,**
**dass** das Verbindungselement einteilig oder mehrteilig ist.
